# EUROPEAN PATENT APPLICATION

(11) **EP 4 593 548 A1**
(43) Date of publication of application: **30.07.2025**
(21) Application number: 24196938.5
(22) Date of filing: 28.08.2024
(51) Int. Cl.: H10B 43/10, H10B 43/50

(54) **SEMICONDUCTOR MEMORY DEVICE, METHOD OF FABRICATING THE SAME, AND ELECTRONIC SYSTEM INCLUDING THE SAME**

(30) Priority: 23.01.2024 KR 20240010122
(71) Applicant: SAMSUNG ELECTRONICS CO., LTD., Yeongtong-gu Suwon-si, Gyeonggi-do 16677 (KR)
(72) Inventor: PARK, Kyeong Hoon, 16677 Suwon-si, Gyeonggi-do (KR); KIM, Hyun Ho, 16677 Suwon-si, Gyeonggi-do (KR); BAEK, Jae-Bok, 16677 Suwon-si, Gyeonggi-do (KR); HAN, Jee Hoon, 16677 Suwon-si, Gyeonggi-do (KR)
(74) Representative: Kuhnen & Wacker Patent- und Rechtsanwaltsbüro PartG mbB

(57) **Abstract**

A semiconductor memory device is provided. The semiconductor memory device includes a source layer, a stack structure including a plurality of gate electrodes sequentially stacked apart from one another, on the source layer, a channel structure extending in a first direction penetrating the gate electrodes and connected to the source layer, a cutting pattern extending in a second direction that intersects the first direction, cutting the stack structure, a cell wiring structure on the stack structure, a channel contact connecting the channel structure and the cell wiring structure, between the stack structure and the cell wiring structure and a line pattern extending in the second direction, between the stack structure and the cell wiring structure, and overlapping with the cutting pattern in the first direction, wherein the line pattern is at a same level as the channel contact.

## Description

### BACKGROUND

The present disclosure relates to semiconductor memory devices, methods of fabricating the same, and electronic systems including the same, and more particularly, to semiconductor memory devices including memory cells that are arranged three-dimensionally, methods of manufacturing the semiconductor memory device, and electronic systems including the semiconductor memory device.

As semiconductor memory devices capable of storing high-capacity data are required in electronic systems, methods to increase the data storage capacity of semiconductor memory devices are being researched. One of the methods to increase the data storage capacity of semiconductor memory devices proposes a semiconductor memory device including memory cells that are arranged three-dimensionally, instead of memory cells that are arranged two-dimensionally.

### SUMMARY

Aspects of the present disclosure provide semiconductor memory devices with improved reliability.

Aspects of the present disclosure also provide methods of fabricating a semiconductor memory device, which can produce a semiconductor memory device with improved reliability.

Aspects of the present disclosure also provide electronic systems including a semiconductor memory device with improved reliability.

According to some aspects of the present disclosure, there is provided a semiconductor memory device including a source layer, a stack structure including a plurality of gate electrodes sequentially stacked apart from one another, on the source layer, a channel structure extending in a first direction penetrating the gate electrodes and connected to the source layer, a cutting pattern extending in a second direction that intersects the first direction, and cutting the stack structure, a cell wiring structure on the stack structure, a channel contact connecting the channel structure and the cell wiring structure, between the stack structure and the cell wiring structure and a line pattern extending in the second direction, between the stack structure and the cell wiring structure, and overlapping with the cutting pattern in the first direction, the line pattern being at a same level as the channel contact.

According to some aspects of the present disclosure, there is provided a semiconductor memory device including a peripheral circuit structure including a peripheral circuit substrate and a peripheral circuit element on the peripheral circuit substrate and a memory cell structure stacked on the peripheral circuit structure, the memory cell structure including a source layer including a first surface facing the peripheral circuit structure and a second surface that is opposite to the first surface, a stack structure including a plurality of gate electrodes sequentially stacked apart from one another, on the source layer, a channel structure extending in a first direction penetrating the gate electrodes and connected to the source layer, a cutting pattern extending in a second direction that intersects the first direction, and cutting the stack structure, a conductive line extending in a third direction that intersects the first and second directions, and being between the stack structure and the peripheral circuit structure, a channel contact connecting the channel structure and the conductive line, and being between the stack structure and the conductive line, and a line pattern extending in the second direction, being between the stack structure and the conductive line, and overlapping with the cutting pattern in the first direction.

According to some example embodiments of the present disclosure, there is provided an electronic system comprising a main substrate, a semiconductor memory device including a peripheral circuit structure and a memory cell structure sequentially stacked, on the main substrate and a controller electrically connected to the semiconductor memory device, on the main substrate, the memory cell structure including a source layer including a first surface facing the peripheral circuit structure and a second surface that is opposite to the first surface, a stack structure including a plurality of gate electrodes sequentially stacked apart from one another, on the source layer, a channel structure extending in a first direction, penetrating the gate electrodes and connected to the source layer, a cutting pattern extending in a second direction that intersects the first direction, cutting the stack structure, a conductive line extending in a third direction that intersects the first and second directions, between the stack structure and the peripheral circuit structure, a channel contact connecting the channel structure and the conductive line, between the stack structure and the conductive line; and a line pattern extending in the second direction, between the stack structure and the conductive line, and overlapping with the cutting pattern in the first direction.

It should be noted that the effects of the present disclosure are not limited to those described above, and other effects of the present disclosure will be apparent from the following description.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects and features of the present disclosure will become more apparent by describing in detail example embodiments thereof with reference to the attached drawings, in which:
FIG. 1 is a block diagram for explaining a semiconductor memory device according to some example embodiments of the present disclosure.
FIG. 2 is a circuit diagram for explaining a semiconductor memory device according to some example embodiments of the present disclosure.
FIG. 3 is a layout view for explaining a semiconductor memory device according to some example embodiments of the present disclosure.
FIG. 4 is a cross-sectional view taken along line A-A of FIG. 3.
FIG. 5 is an enlarged cross-sectional view of an area Z1 of FIG. 4.
FIG. 6 is an enlarged cross-sectional view of an area R of FIG. 3.
FIG. 7 is a cross-sectional view taken along line B-B of FIG. 6.
FIG. 8 is an enlarged cross-sectional view of an area Z2 of FIG. 7.
FIGS. 9 through 11 are cross-sectional views for explaining semiconductor memory devices according to some example embodiments of the present disclosure.
FIG. 12 is a layout view for explaining a semiconductor memory device according to some example embodiments of the present disclosure.
FIG. 13 is a layout view for explaining a semiconductor memory device according to some example embodiments of the present disclosure.
FIG. 14 is a cross-sectional view taken along line C-C of FIG. 13.
FIG. 15 is an enlarged cross-sectional view of an area Z3 of FIG. 14.
FIGS. 16 through 31 are cross-sectional views illustrating intermediate steps of a method of fabricating a semiconductor memory device according to some example embodiments of the present disclosure.
FIGS. 32 through 42 are cross-sectional views illustrating intermediate steps of a method of fabricating a semiconductor memory device according to some example embodiments of the present disclosure.
FIG. 43 is a block diagram for explaining an electronic system according to some example embodiments of the present disclosure.
FIG. 44 is a perspective view for explaining an electronic system according to some example embodiments of the present disclosure.
FIG. 45 is a cross-sectional view taken along line I-I of FIG. 44.

### DETAILED DESCRIPTION

In this specification, although terms such as "first," "second," etc., are used to describe various elements or components, these elements or components are not limited by these terms. These terms are used merely to distinguish one element or component from another. Therefore, a first element or component mentioned below may also be a second element or component within the technical spirit of the disclosure.

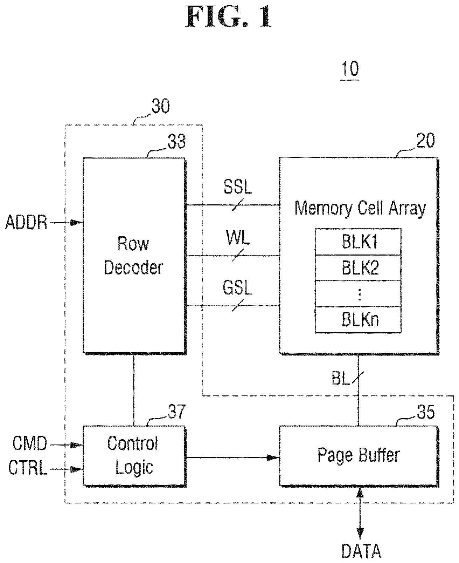

A semiconductor memory device according to some example embodiments of the present disclosure will hereinafter be described with reference to FIGS. 1 through 15.

FIG. 1 is a block diagram for explaining a semiconductor memory device according to some example embodiments of the present disclosure.

Referring to FIG. 1, a memory cell array 20 of a semiconductor memory device 10 may include a plurality of memory cell blocks BLK1 through BLKn. Each of the memory cell blocks BLK1 through BLKn may include a plurality of memory cells. The memory cell array 20 may be connected to peripheral circuitry 30 through bitlines BL, wordlines WL, one or more string select lines SSL, and one or more ground select lines GSL. For example, the memory cell blocks BLK1 through BLKn may be connected to a row decoder 33 through the wordlines WL, the string select lines SSL, and the ground select lines GSL. Additionally, the memory cell blocks BLK1 through BLKn may be connected to a page buffer 35 through the bitlines BL.

The peripheral circuitry 30 may receive addresses ADDR, commands CMD, and control signals CTRL from outside the semiconductor memory device 10 and may exchange data DATA with an external device outside the semiconductor memory device 10. The peripheral circuitry 30 may include control logic 37, the row decoder 33, and the page buffer 35. Although not illustrated, the peripheral circuitry 30 may further include various subcircuits such as an input/output circuit, a voltage generation circuit that generates various voltages required for the operation of the semiconductor memory device 10, and an error correction circuit that corrects error in the data DATA read from the memory cell array 20.

The control logic 37 may be connected to the row decoder 33, the input/output circuit, and the voltage generation circuit. The control logic 37 may control the overall operation of the semiconductor memory device 10. The control logic 37 may generate various internal control signals for use in the semiconductor memory device 10 in response to the control signals CTRL. For example, the control logic 37 may adjust the voltage level to be provided to the wordlines WL and the bitlines BL during a memory operation such as programming or erasing.

In response to the addresses ADDR, the row decoder 33 may select at least one of the memory cell blocks BLK1 through BLKn, and may choose at least one wordline WL, at least one string select line SSL, and at least one ground select line GSL from the selected memory cell block(s). Furthermore, the row decoder 33 may deliver voltages to the wordlines WL of the selected memory cell block(s) for performing a memory operation.

The page buffer 35 may be connected to the memory cell array 20 through the bitlines BL. The page buffer 35 may operate as a write driver or a sense amplifier. For example, during a program operation, the page buffer 35 operates as a write driver, applying a voltage corresponding to the data DATA to be stored in the memory cell array 20 to the bitlines BL. Conversely, during a read operation, the page buffer 35 operates as a sense amplifier, detecting the data DATA stored in the memory cell array 20.

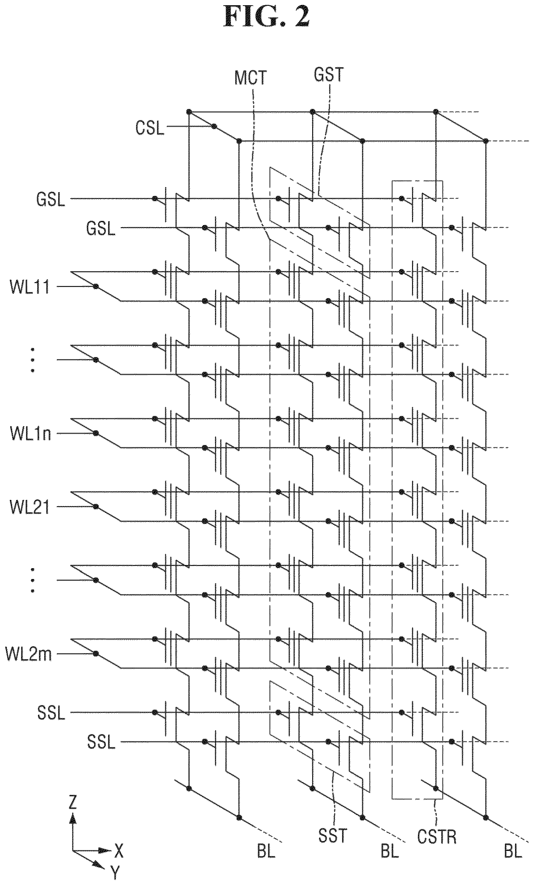

FIG. 2 is a circuit diagram for explaining a semiconductor memory device according to some example embodiments of the present disclosure.

Referring to FIG. 2, a memory cell array (for example, the memory cell array 20 of FIG. 1) of the semiconductor memory device according to some example embodiments of the present disclosure includes a common source line CSL, a plurality of bitlines BL, and a plurality of cell strings CSTR.

The bitlines BL may be arranged two-dimensionally in a plane including first and second directions X and Y. For example, the bitlines BL may extend in the second direction Y and may be spaced apart from one another along the first direction X. The cell strings CSTR may be connected in parallel to the bitlines BL. The cell strings CSTR may be connected in common to the common source line CSL. That is, the cell strings CSTR may be disposed between the bitlines BL and the common source line CSL.

Each of the cell strings CSTRs may include a ground select transistor GST, which is connected to the common source line CSL, a string select transistor SST, which is connected to the bitlines BL, and a plurality of memory cell transistors MCT, which are disposed between the ground select transistor GST and the string select transistor SST. Each of the memory cell transistors MCT may include a data storage element. The ground select transistor GST, the string select transistor SST, and the memory cell transistors MCT may be connected in series in a third direction Z, which intersects the first and second directions X and Y.

The common source line CSL may be connected in common to the sources of the ground select transistors GST. Additionally, the ground select lines GSL, a plurality of wordlines (WL11 through WL1n and WL21 through WL2m), and the string select lines SSL may be disposed between the common source line CSL and the bitlines BL. The ground select line GSL may serve as the gate electrodes of the ground select transistors GST, wordlines WL1 through WLn may serve as the gate electrodes of the memory cell transistors MCT, and the string select lines SSL may serve as the gate electrodes of the string select transistors SST.

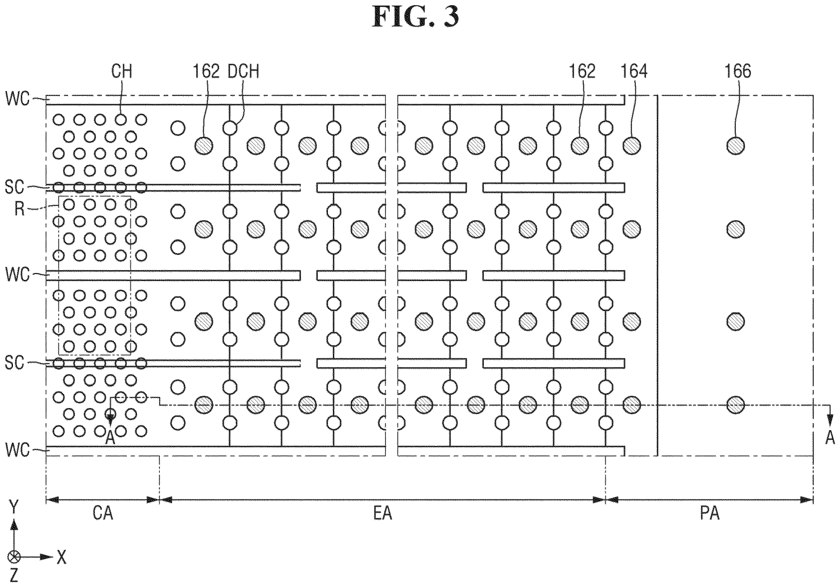

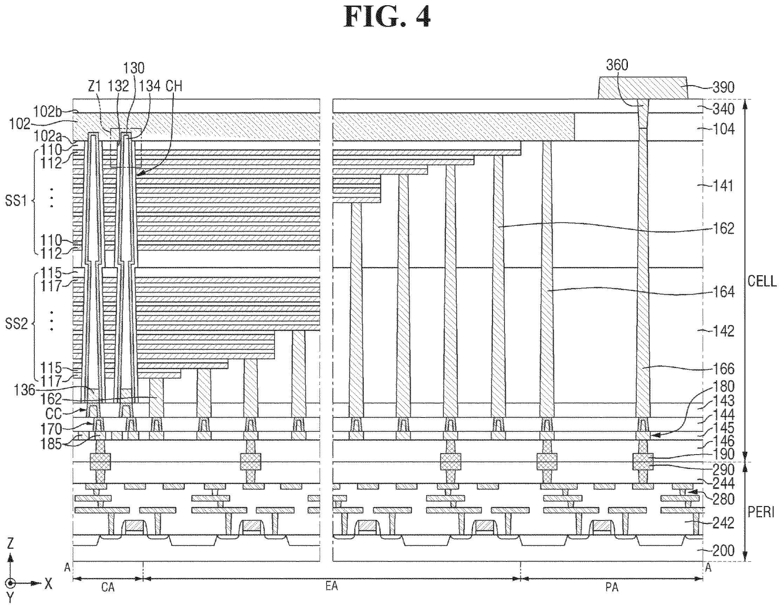

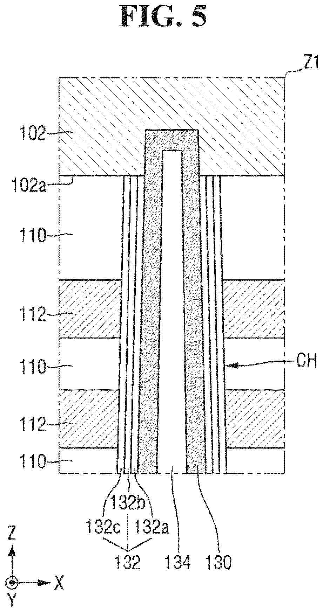

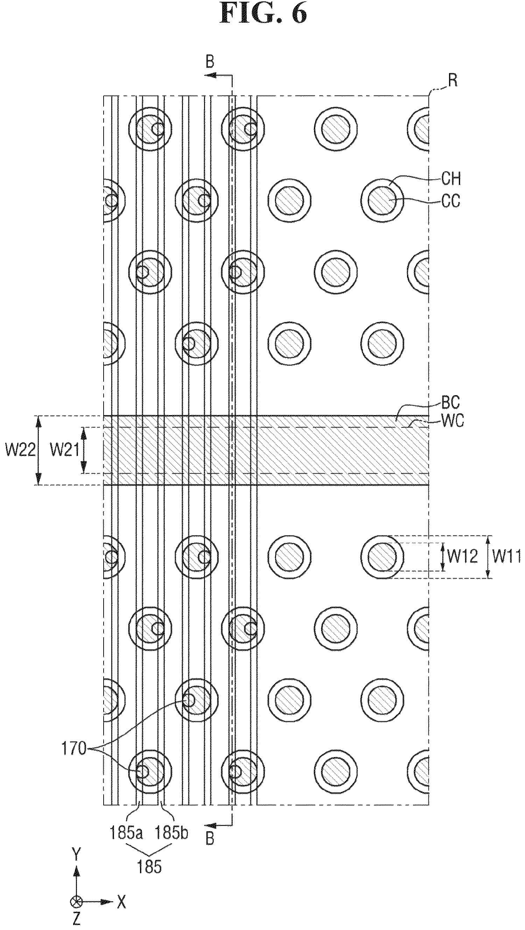

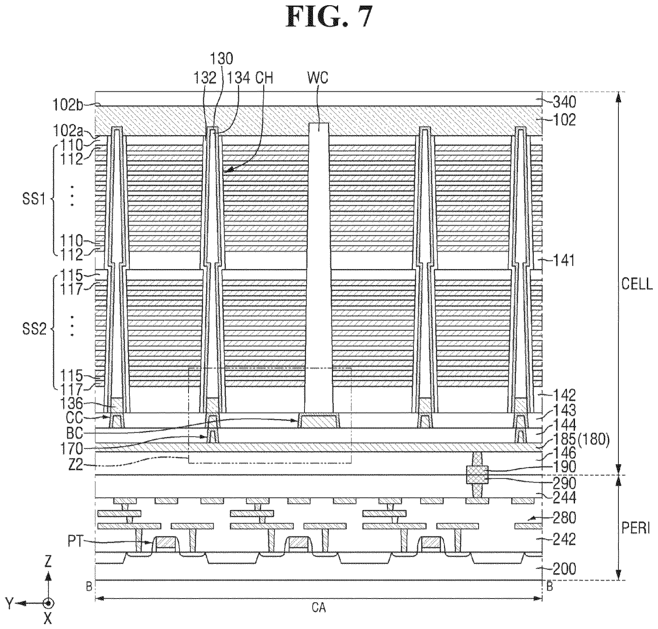

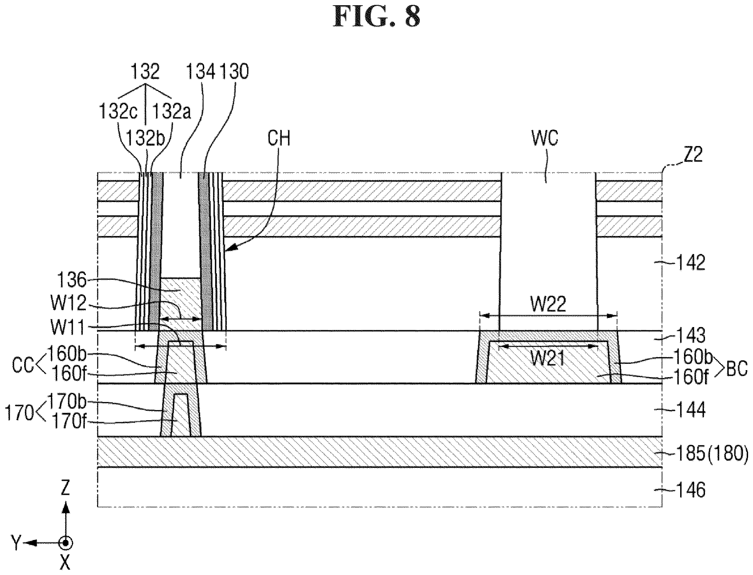

FIG. 3 is a layout view for explaining a semiconductor memory device according to some example embodiments of the present disclosure. FIG. 4 is a cross-sectional view taken along line A-A of FIG. 3. FIG. 5 is an enlarged cross-sectional view of an area Z1 of FIG. 4. FIG. 6 is an enlarged cross-sectional view of an area R of FIG. 3. FIG. 7 is a cross-sectional view taken along line B-B of FIG. 6. FIG. 8 is an enlarged cross-sectional view of an area Z2 of FIG. 7.

Referring to FIGS. 3 through 8, the semiconductor memory device according to some example embodiments of the present disclosure includes a memory cell structure CELL, a peripheral circuit structure PERI, and conductive pads 390.

The memory cell structure CELL may include a cell array area CA, an extension area EA, and an external area PA.

In the cell array area CA, a memory cell array (for example, the memory cell array 20 of FIG. 1) including a plurality of memory cells may be formed. For example, a source layer 102, channel structures CH, gate electrodes (112 and 117), and bitlines BL that will be described later may be disposed in the cell array area CA.

The extension area EA may be disposed around the cell array area CA. For example, the extension area EA may be adjacent to the cell array area CA in a first direction X. In each of the extension area EA, the gate electrodes (112 and 117) that will be described later may be stacked in a stepwise fashion.

The external area PA may be a surrounding area encircling the cell array area CA and the extension area EA. For example, the external area PA may be adjacent to the cell array area CA and/or the extension area EA in the first direction X and/or a second direction Y. The conductive pads 390 that will be described later may be disposed in the external area PA.

The memory cell structure CELL may include the source layer 102, an insulating substrate 104, a stack structure (SS1 and SS2), the channel structures CH, cutting patterns WC, gate contacts 162, source contacts 164, through vias 166, channel contacts CC, blocking patterns BC, first contact patterns 170, and cell wiring structures 180.

The source layer 102 may include a conductive material, such as doped polysilicon, a metal, or a metal silicide, but the present disclosure is not limited thereto. For example, the source layer 102 may include polysilicon doped with n-type impurities, such as phosphorus (P) or arsenic (As). The source layer 102 may be provided as a common source line (for example, the common source line CSL of FIG. 2) for the semiconductor memory device according to some example embodiments of the present disclosure.

The source layer 102 may include first and second surfaces 102a and 102b, which are opposite to each other. The first surface 102a may also be referred to as the front side of the source layer 102, and the second surface 102b may also be referred to as the back side of the source layer 102.

The insulating substrate 104 may be formed near the source layer 102. The insulating substrate 104 may form an insulating area around the source layer 102 across the cell array area CA and/or the external area PA. The insulating substrate 104 may include, for example, at least one of silicon oxide, silicon nitride, silicon oxynitride, and silicon carbide, but the present disclosure is not limited thereto.

The stack structure (SS1 and SS2) may be formed on the first surface 102a of the source layer 102. The stack structure (SS1 and SS2) may include a plurality of gate electrodes (112 and 117) and a plurality of mold insulating films (110 and 115), which are stacked on the source layer 102 along with the gate electrodes (112 and 117). Each of the gate electrodes (112 and 117) and mold insulating films (110 and 115) may have a layered structure extending in a horizontal direction (for example, the first or second direction X or Y). The gate electrodes (112 and 117) may be sequentially stacked by being spaced apart from one another by the mold insulating films (110 and 115).

The gate electrodes (112 and 117) in the extension area EA may be stacked in a stepwise fashion on the source layer 102. For example, in the extension area EA, the length of extension of the gate electrodes (112 and 117) in the first direction X may decrease away from the source layer 102.

In some example embodiments, the stack structure (SS1 and SS2) may include a plurality of stacks that are sequentially stacked on the source layer 102, here, for example, first and second stacks SS1 and SS2. The stack structure (SS1 and SS2) is illustrated as including two stacks, but the present disclosure is not limited thereto. Alternatively, the stack structure (SS1 and SS2) may include three or more stacks.

The first stack SS1 may include first mold insulating films 110 and first gate electrodes 112, which are stacked on the source layer 102 alternating with the first mold insulating films 110. In some example embodiments, the first gate electrodes 112 may include one or more ground select lines (for example, the ground selection lines GSL of FIG. 2) and a plurality of first wordlines (for example, wordlines WL11 through WL1n of FIG. 2), which are sequentially stacked on the source layer 102. The numbers and shapes of the first mold insulating films 110 and the first gate electrodes 112 are merely examples and are not particularly limited.

A first interlayer insulating film 141, which covers the first stack SS1, may be formed on the source layer 102 and the insulating substrate 104. The first interlayer insulating film 141 may include, for example, at least one of silicon oxide, silicon oxynitride, and a low-k material with a smaller dielectric constant than silicon oxide, but the present disclosure is not limited thereto.

The second stack SS2 may include second mold insulating films 115 and second gate electrodes 117, which are stacked on the first stack SS1 alternating with the second mold insulating films 115. In some example embodiments, the second gate electrodes 117 may include a plurality of second wordlines (for example, wordlines WL21 through WL2m of FIG. 2) and one or more string select lines (for example, the string select lines SSL of FIG. 2), which are sequentially stacked on the first stack SS1. The numbers and shapes of the second mold insulating films 115 and the second gate electrodes 117 are merely examples and are not particularly limited.

A second interlayer insulating film 142, which covers the second stack SS2, may be formed on the first interlayer insulating film 141. The second interlayer insulating film 142 may include, for example, at least one of silicon oxide, silicon nitride, silicon oxynitride, and a low-k material with a smaller dielectric constant than silicon oxide, but the present disclosure is not limited thereto.

The gate electrodes (112 and 117) may include a conductive material, for example, a metal such as tungsten (W), molybdenum (Mo), ruthenium (Ru), cobalt (Co), or nickel (Ni), or a semiconductor material such as silicon (Si), but the present disclosure is not limited thereto. For example, the gate electrodes (112 and 117) may contain at least one of W, Mo, and Ru. In another example, the gate electrodes (112 and 117) may contain polysilicon.

Mold insulating films (110 and 115) may include, for example, at least one of silicon oxide, silicon nitride, and silicon oxynitride, but the present disclosure is not limited thereto. For example, the mold insulating films (110 and 115) may include silicon oxide.

The channel structures CH may be disposed in the cell array area CA. The channel structures CH may be formed on the source layer 102. The channel structures CH may extend in a third direction Z, which intersects the first and second directions X and Y, and may thereby penetrate the stack structure (SS1 and SS2). For example, the channel structures CH may be in the shape of pillars (e.g., cylinders) extending in the third direction Z. The channel structures CH may intersect the gate electrodes (112 and 117).

The channel structures CH may be electrically connected to the source layer 102. For example, the upper surfaces of the channel structures CH may be formed to be coplanar with, or higher than, the first surface 102a of the source layer 102.

In some example embodiments, the channel structures CH may be arranged in a zigzag fashion. As illustrated in FIGS. 3 and 6, the channel structures CH may be staggered in the first and second directions X and Y. The channel structures CH can enhance the integration density of the semiconductor memory device according to some example embodiments of the present disclosure. The number and arrangement of channel structures CH are merely examples and are not particularly limited.

In some example embodiments, each of the channel structures CH may have a step difference between the first and second stacks SS1 and SS2. For example, as illustrated in FIG. 4, the sides of each of the channel structures CH may have a bending portion at the boundary between the first interlayer insulating film 141 and the second stack SS2.

The channel structures CH may include semiconductor films 130 and data storage films 132.

The semiconductor films 130 may extend in the third direction Z and may intersect the gate electrodes (112 and 117). The semiconductor films 130 are illustrated as being cup-shaped, but the present disclosure is not limited thereto. Alternatively, the semiconductor films 130 may have various other shapes such as a cylindrical, rectangular prism, or filled pillar shape. The semiconductor films 130 may include, for example, monocrystalline silicon, polycrystalline silicon, an organic semiconductor, and carbon nanostructures, but the present disclosure is not limited thereto.

The semiconductor films 130 may be connected to the source layer 102. For example, ends (for example, upper ends) of the semiconductor films 130 may be exposed from the data storage films 132 and may be connected to the source layer 102. In some example embodiments, the semiconductor films 130 may penetrate the first surface 102a of the source layer 102. For example, the ends (for example, the upper ends) of the semiconductor films 130 may protrude above the data storage films 132. The semiconductor films 130 can enhance the contact area with the source layer 102, thereby reducing contact resistance.

The data storage films 132 may be interposed between the semiconductor films 130 and the gate electrodes (112 and 117). For example, the data storage films 132 may extend along the outer side surfaces of the semiconductor films 130. The data storage films 132 may include, for example, at least one of silicon oxide, silicon nitride, silicon oxynitride, and a high-k material with a greater dielectric constant than silicon oxide, but the present disclosure is not limited thereto. The high-k material may include, for example, at least one of aluminum oxide, hafnium oxide, lanthanum oxide, tantalum oxide, titanium oxide, lanthanum hafnium oxide, lanthanum aluminum oxide, dysprosium scandium oxide, and a combination thereof.

In some example embodiments, the data storage films 132 may be formed as multilayers. For example, as illustrated in FIGS. 5 and 8, each of the data storage films 132 may include a tunnel insulating film 132a, a charge storage film 132b, and a blocking insulating film 132c, which are sequentially stacked on the outer side surfaces of the corresponding semiconductor film 130.

The tunnel insulating films 132a may include, for example, silicon oxide or a high-k material with a greater dielectric constant than silicon oxide (for example, aluminum oxide (Al₂O₃) or hafnium oxide (HfO₂)). The charge storage films 132b may include, for example, silicon nitride. The blocking insulating films 132c may include, for example, silicon oxide or a high-k material with a greater dielectric constant than silicon oxide (for example, Al₂O₃ or HfO₂).

In some example embodiments, the channel structures CH may further include fill insulating films 134. The fill insulating films 134 may be formed to fill the inside of the cup-shaped semiconductor films 130. The fill insulating films 134 may include, for example, an insulating material such as silicon oxide, but the present disclosure is not limited thereto. For example, the fill insulating films 134 may extend beyond the data storage films 132 at ends (for example, upper ends).

In some example embodiments, the channel structures CH may further include channel pads 136. The channel pads 136 may be formed to be connected to other ends (for example, lower ends) of the semiconductor films 130. The channel pads 136 may contain a conductive material such as doped polysilicon, a metal, or a metal silicide, but the present disclosure is not limited thereto.

In some example embodiments, dummy channel structures DCH may be formed within the extension area EA. The dummy channel structures DCH may extend in the third direction Z, penetrating at least parts of the stack structure (SS1 and SS2).

The dummy channel structures DCH may be formed at the same level as or at a different level from the channel structures CH. For example, if formed at the same level as the channel structures CH, the dummy channel structures DCH may also include the semiconductor films 130, the data storage films 132, the fill insulating films 134, and the channel pads 136. Alternatively, if formed at a different level from the channel structures CH, the dummy channel structures DCH may be filled with an insulating material and/or a conductive material. The size (here, for example, width) of the dummy channel structures DCH may be the same as or different from the size of the channel structures CH. In some example embodiments, the size of the dummy channel structures DCH may be greater than the size of the channel structures CH.

The cutting patterns WC may be disposed across the cell array area CA and the extension area EA. The cutting patterns WC may extend longitudinally in the first direction X and may thereby cut the stack structure (SS 1 and SS2). Moreover, the cutting patterns WC may be spaced apart from one another, extending in parallel in the first direction X. The stack structure (SS1 and SS2) may be divided by the cutting patterns WC, thereby forming a plurality of memory cell blocks (for example, the memory cell blocks BLK1 through BLKn of FIG. 1). For example, two adjacent cutting patterns WC may define a single memory cell block therebetween. Multiple channel structures CH may be disposed in each of the memory cell blocks defined by the cutting patterns WC.

In some example embodiments, the cutting patterns WC may include an insulating material, for example, at least one of silicon oxide, silicon nitride, and silicon oxynitride, but the present disclosure is not limited thereto. For example, the cutting patterns WC may include a silicon oxide film.

In some example embodiments, separation patterns SC may be formed within the second stack SS2. The separation patterns SC may extend in the first direction X, cutting the string select lines (for example, the string select lines SSL of FIG. 2) of the second stack SS2, for example, the lowermost second gate electrodes 117. Each of the memory cell blocks defined by the cutting patterns WC may be divided by the separation patterns SC to form multiple string areas. For example, one separation pattern SC may define two string areas within a single memory cell block. The separation patterns SC may include an insulating material, for example, at least one of silicon oxide, silicon nitride, and silicon oxynitride, but the present disclosure is not limited thereto.

The gate contacts 162 may be disposed in the extension area EA. The gate contacts 162 may be electrically connected to the gate electrodes (112 and 117). For example, a third interlayer insulating film 143, which covers the channel structure CH and the second interlayer insulating film 142, may be formed. A plurality of gate contacts 162 may extend in the third direction Z, penetrating the third and second interlayer insulating films 143 and 142, and may be connected to the corresponding gate electrodes (112 and 117). In some example embodiments, the width of the gate contact 162 may decrease closer to the corresponding gate electrodes (112 and 117).

The source contacts 164 may be disposed in the external area PA. The source contacts 164 may be electrically connected to the source layer 102. For example, the source contacts 164 may extend in the third direction Z, penetrating the third and second interlayer insulating films 143 and 142, and may be connected to the source layer 102 exposed from the stack structure (SS1 and SS2). In some example embodiments, the width of the source contact 164 may decrease closer to the source layer 102.

The through vias 166 may be disposed in the external area PA. The through vias 166 may overlap with the insulating substrate 104 in the third direction Z. For example, the through vias 166 may extend in the third direction Z, penetrating the third and second interlayer insulating films 143 and 142, and may be connected to the insulating substrate 104. In some example embodiments, the width of the through vias 166 may decrease closer to the insulating substrate 104. In some example embodiments, the upper surface of the through vias 166 may be formed to be coplanar with, or higher than, the lower surface of the insulating substrate 104.

The channel contacts CC may be formed on the channel structures CH. The channel contacts CC may be electrically connected to the channel structures CH. For example, the channel contacts CC may penetrate the third interlayer insulating film 143 and may thereby be connected to ends of the channel structure CH, for example, lower ends of the channel pads 136. In some example embodiments, the width of the channel contacts CC may decrease closer to the channel structures CH.

In some example embodiments, the channel contacts CC may have a smaller width than the channel structures CH. For example, at the interfaces between the channel structures CH and the channel contacts CC (or the interface between the second and third interlayer insulating films 142 and 143), a width W12 of the channel contacts CC may be smaller than a width W11 of the channel structures CH.

The blocking patterns BC may be formed on the cutting patterns WC. The blocking patterns BC may overlap with the cutting patterns WC in the third direction Z. For example, the blocking patterns BC may extend longitudinally in the first direction X within the third interlayer insulating film 143. The blocking patterns BC may also be referred to as line patterns. In some example embodiments, the blocking patterns BC may directly contact the cutting patterns WC. In some example embodiments, the width of the blocking patterns BC may decrease closer to the cutting patterns WC.

In some example embodiments, the blocking patterns BC may have a greater width than the cutting patterns WC. Here, the term "width" refers to the width in the second direction Y. For example, at the interfaces between the cutting patterns WC and the blocking patterns BC (or at the interface between the second and third interlayer insulating films 142 and 143), a width W22 of the blocking pattern BC may be larger than a width W21 of the cutting pattern WC.

In some example embodiments, the blocking patterns BC may be disposed at the same level as the channel contacts CC. The expression "disposed at the same level" means being disposed at the same height in a vertical direction (for example, the third direction Z). The lower surfaces of the blocking patterns BC may be disposed coplanar with the lower surfaces of the channel contacts CC. Similarly, the upper surfaces of the blocking patterns BC may be disposed coplanar with the upper surfaces of the channel contacts CC. Moreover, the expression "the same" not only means being completely identical, but also encompasses the presence of minor differences that may arise due to process margins, etc.

In some example embodiments, the blocking patterns BC may be formed at the same level as the channel contacts CC. Here, the expression "formed at the same level" means being formed by the same manufacturing process. For example, the blocking patterns BC may include the same material as the channel contacts CC. Alternatively, the blocking patterns BC may have the same material composition as the channel contacts CC.

In some example embodiments, each of the channel contacts CC and blocking patterns BC may include a first barrier conductive film 160b and a first filling conductive film 160f, which are sequentially stacked on the second interlayer insulating film 142.

The first barrier conductive films 160b may contain a metal or metal nitride to prevent or reduce the diffusion of the first filling conductive films 160f. The first barrier conductive films 160b may include, for example, at least one of titanium (Ti), tantalum (Ta), tungsten (W), Ni, Co, platinum (Pt), an alloy thereof, and a nitride thereof, but the present disclosure is not limited thereto. For example, the first barrier conductive films 160b may include a titanium nitride film.

The first filling conductive films 160f may be formed to fill areas on the first barrier conductive films 160b. The first filling conductive films 160f may include, for example, at least one of aluminum (Al), copper (Cu), W, Mo, Co, Ru, and an alloy thereof, but the present disclosure is not limited thereto. For example, the first filling conductive films 160f may include a W film.

The first contact patterns 170 may be formed on the third interlayer insulating film 143. The first contact patterns 170 may be electrically connected to the gate contacts 162, the source contacts 164, the through vias 166, and/or the channel contacts CC. For example, a fourth interlayer insulating film 144, which covers the third interlayer insulating film 143, the gate contacts 162, the source contacts 164, the through vias 166, the channel contacts CC, and the blocking patterns BC, may be formed. The first contact patterns 170 may be connected to the gate contacts 162, the source contacts 164, the through vias 166, and/or the channel contacts CC by penetrating the fourth interlayer insulating film 144. In some example embodiments, the width of the first contact patterns 170 may decrease closer to the third interlayer insulating film 143.

In some example embodiments, each of the first contact patterns 170 may include a second barrier conductive film 170b and a second filling conductive film 170f, which are sequentially stacked on the third interlayer insulating film 143.

The second barrier conductive films 170b may contain a metal or a metal nitride to prevent or reduce the diffusion of the second filling conductive films 170f. The second barrier conductive films 170b may include, for example, at least one of Ti, Ta, W, Ni, Co, Pt, an alloy thereof, and a nitride thereof, but the present disclosure is not limited to. For example, the second barrier conductive films 170b may include a titanium nitride film.

The second filling conductive films 170f may be formed to fill areas on the second barrier conductive films 170b. The second filling conductive films 170f may include, for example, at least one of Al, Cu, W, Mo, Co, Ru, and an alloy thereof, but the present disclosure is not limited thereto. For example, the second filling conductive films 170f may include a W film.

The cell wiring structures 180 may be formed on the fourth interlayer insulating film 144. The cell wiring structures 180 may be electrically connected to the first contact patterns 170. For example, a first inter-wiring insulating film 145, which covers the fourth interlayer insulating film 144 and the first contact patterns 170, may be formed. The cell wiring structures 180 may be formed within the first inter-wiring insulating film 145 and may thereby be connected to the first contact patterns 170. The number of layers and the arrangement of the cell wiring structures 180 are merely examples and are not particularly limited.

The cell wiring structures 180 may include a conductive material, such as Al, Cu, W, Mo, Co, Ru, or an alloy thereof, but the present disclosure is not limited thereto. For example, the cell wiring structures 180 may include Cu wiring.

In some example embodiments, the cell wiring structures 180 may include conductive lines 185, which are disposed in the cell array area CA. The conductive lines 185 may extend longitudinally in the second direction Y. Moreover, the conductive lines 185 may be spaced apart from one another, extending in parallel in the second direction Y.

The conduction lines 185 may be electrically connected to the channel structures CH, which are arranged along the second direction Y. For example, as illustrated in FIG. 6, the conduction lines 185 may overlap in the third direction Z with the channel structures CH, which are arranged along the second direction Y. The conduction lines 185 may be electrically connected to the channel structures CH through the first contact patterns 170 and the channel contacts CC. The conduction lines 185 may be provided as bitlines (for example, the bitlines BL of FIG. 2) in the semiconductor memory device according to some example embodiments of the present disclosure.

In some example embodiments, the conduction lines 185 may include first bitlines 185a and second bitlines 185b, which are adjacent to one another in the first direction X. The first bitlines 185a and the second bitlines 185b may be alternately arranged along the first direction X. Additionally, the channel structures CH may overlap with both the first bitlines 185a and the second bitlines 185b. For example, one of two adjacent channel structures CH in the second direction Y may be connected to a first bitline 185a, and the other channel structure CH may be connected to a second bitline 185b. The conduction lines 185 can further enhance the density of the semiconductor memory device according to some example embodiments of the present disclosure.

The peripheral circuit structure PERI may include a peripheral circuit substrate 200, peripheral circuit elements PT, and peripheral circuit wiring structures 280.

The peripheral circuit substrate 200 may include a semiconductor substrate such as a Si, germanium (Ge), or silicon-germanium (SiGe) substrate. Alternatively, the peripheral circuit substrate 200 may include a silicon-on-insulator (SOI) or germanium-on-insulator (GOI) substrate.

The peripheral circuit elements PT may be formed on the peripheral circuit substrate 200. The peripheral circuit elements PT may form peripheral circuitry (for example, the periphery circuitry 30 of FIG. 1), which controls the operation of the semiconductor memory device according to some example embodiments of the present disclosure. For example, the peripheral circuit elements PT may include control logic (for example, the control logic 37 of FIG. 1), a row decoder (for example, the row decoder 33 of FIG. 1), and a page buffer (for example, the page buffer 35 of FIG. 1). The surface of the peripheral circuit substrate 200 where the peripheral circuit elements PT are disposed may be referred to as the front side of the peripheral circuit substrate 200. Conversely, the surface of the peripheral circuit substrate 200 that is opposite to the front side of the peripheral circuit substrate 200 may be referred to as the back side of the peripheral circuit substrate 200.

The peripheral circuit elements PT may include, for example, transistors, but the present disclosure is not limited thereto. The peripheral circuit elements PT may include not only active elements such as transistors, but also passive elements such as capacitors, resistors, or inductors.

The peripheral circuit wiring structures 280 may be formed on the peripheral circuit elements PT. For example, a second inter-wiring insulating film 242 may be formed on the front side of the peripheral circuit substrate 200. The peripheral circuit wiring structures 280 may be formed in the second inter-wiring insulating film 242 and may be electrically connected to the peripheral circuit elements PT. The number of layers and the arrangement of the peripheral circuit wiring structures 280 are merely examples and are not particularly limited.

In some example embodiments, the memory cell structure CELL may be stacked on the peripheral circuit structure PERI. For example, the memory cell structure CELL may be stacked on the second inter-wiring insulating film 242.

In some example embodiments, the first surface 102a of the source layer 102 may face the peripheral circuit structure PERI. For example, the stack structure (SS1 and SS2) may be interposed between the source layer 102 and the peripheral circuit structure PERI.

The semiconductor memory device according to some example embodiments of the present disclosure may have a chip-to-chip (C2C) structure. The C2C structure involves fabricating an upper chip including the memory cell structure CELL on a first wafer, fabricating a lower chip including the peripheral circuit structure PERI on a second wafer, which is different from the first wafer, and bonding the upper and lower chips together.

For example, the upper and lower chips may be bonded together by electrically connecting first bonding metals 190 (and/or a first bonding insulating film 146) formed in the uppermost metal layer of the upper chip and second bonding metals 290 (and/or a second bonding insulating film 244) formed in the uppermost metal layer of the lower chip. For example, if the first bonding metals 190 and the second bonding metals 290 are formed of Cu, the upper and lower chips may be bonded in a Cu-Cu bonding method, but the present disclosure is not limited thereto. The first bonding metals 190 and the second bonding metals 290 may be formed of various other metals such as Al or W.

As the first bonding metals 190 and the second bonding metals 290 are bonded together, the cell wiring structures 180 may be electrically connected to the peripheral circuit wiring structures 280. Consequently, the memory cells formed in the cell array area CA may be electrically connected to the peripheral circuit elements PT.

The conductive pads 390 may be formed on the second surface 102b of the source layer 102. For example, an upper insulating film 340, which covers the second surface 102b of the source layer 102 and the insulating substrate 104, may be formed. The conductive pads 390 may be formed on the upper surface of the upper insulating film 340.

In some example embodiments, the conductive pads 390 may be disposed within the external area PA. The conductive pads 390 may be electrically connected to the memory cell structure CELL and/or the peripheral circuit structure PERI. For example, second contact pattern 360, which are connected to the through vias 166 by penetrating the upper insulating film 340, may be formed. The conductive pads 390 may be electrically connected to the peripheral circuit structure PERI through the through vias 166.

To improve the integration density of a semiconductor memory device, a semiconductor memory device with the C2C structure is being researched. In the C2C structure, as the upper and lower chips are connected by bonding, the common source line (for example, the source layer 102) of the upper chip may be disposed at the top of the semiconductor memory device.

Meanwhile, a laser annealing process may be performed on the common source line to activate the impurities included in the common source line. However, laser light used in the laser annealing process may be irradiated onto wiring (for example, the conductive lines 185), penetrating structures (for example, the cutting patterns WC) that are formed of a material with high transmittance below the common source line. As a result, wiring defects that may be caused by copper migration may occur.

Conversely, the semiconductor memory device according to some example embodiments of the present disclosure can prevent or reduce wiring defects using the blocking patterns BC. For example, as described above, the blocking patterns BC may be interposed between the cutting patterns WC and the cell wiring structures 180 and overlap with the cutting patterns WC in the third direction Z. The blocking patterns BC can prevent or reduce defects in the cell wiring structures 180 by blocking laser light passing through the cutting patterns WC during a laser annealing process. In this manner, a semiconductor memory device with improved reliability can be provided.

Additionally, in the semiconductor memory device according to some example embodiments of the present disclosure, the blocking patterns BC may be disposed at the same level as the channel contacts CC. For example, as mentioned earlier, the blocking patterns BC may be formed at the same level as the channel contacts CC. Therefore, a semiconductor memory device with improved reliability can be provided without additional cost.

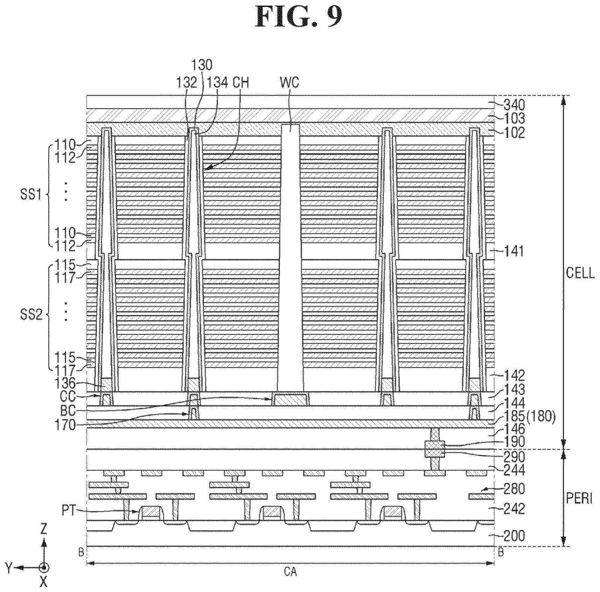

FIGS. 9 through 11 are cross-sectional views for explaining semiconductor memory devices according to some example embodiments of the present disclosure. For convenience, descriptions of content that overlaps with what has been described above with reference to FIGS. 1 through 8 will be simplified or omitted.

Referring to FIGS. 6 and 9, the semiconductor memory device according to some example embodiments of the present disclosure may further include a conductive plate 103.

The conductive plate 103 may be formed on the back side of a source layer 102. The conductive plate 103 may be interposed between the source layer 102 and an upper insulating film 340. The conductive plate 103 may be electrically connected to the source layer 102. For example, the conductive plate 103 may contact the back side of the source layer 102. The conductive plate 103 may include a conductive material, for example, a metal such as W, Co, or Ni, or a metal silicide, but the present disclosure is not limited thereto. The conductive plate 103 may be used to reduce the electrical resistance of a common source line (for example, the common source line CSL of FIG. 2) that includes the source layer 102.

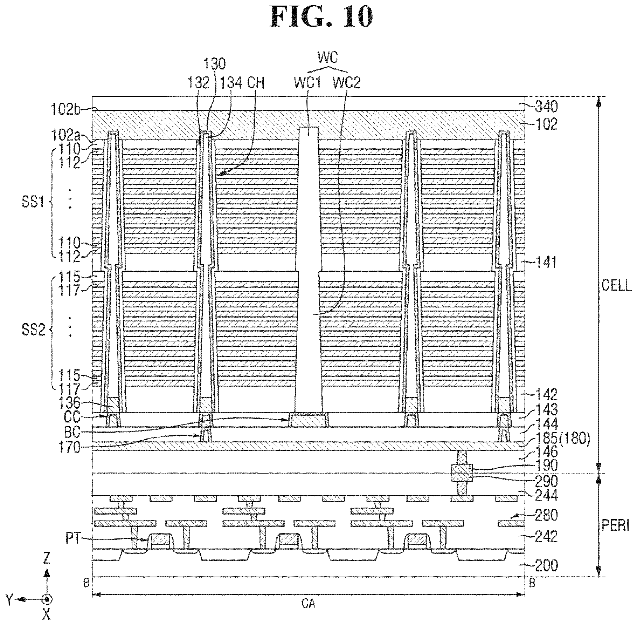

Referring to FIGS. 6 and 10, the semiconductor memory device according to some example embodiments of the present disclosure may include first and second cutting patterns WC1 and WC2.

The first cutting pattern WC1 may extend in a first direction X and may thereby cut a first stack SS1. The second cutting pattern WC2 may extend in the first direction X and may thereby cut a second stack SS2. The first and second cutting patterns WC1 and WC2 may be connected to each other in a third direction Z.

The first cutting pattern WC1 may have a tapered shape toward the source layer 102. For example, the width of the first cutting pattern WC1 may decrease closer to the source layer 102. This may be because an etching process for forming the first cutting pattern WC1 is performed in a direction toward the source layer 102, for example, in the third direction Z.

The second cutting pattern WC2 may have a tapered shape toward the first cutting pattern WC1. For example, the width of the second cutting pattern WC2 may decrease closer to the first cutting pattern WC1. This may be because an etching process for forming the second cutting pattern WC2 is performed in a direction toward the first cutting pattern WC1, for example, in the third direction Z.

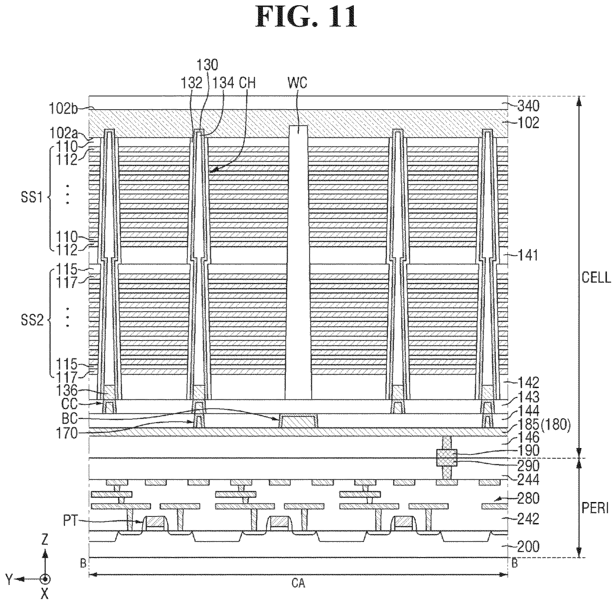

Referring to FIGS. 6 and 11, in the semiconductor memory device according to some example embodiments of the present disclosure, a blocking pattern BC (or a line pattern) may be disposed at the same level as first contact patterns 170.

For example, the lower surface of the blocking pattern BC may be disposed coplanar with the lower surfaces of the first contact patterns 170. Similarly, the upper surface of the blocking pattern BC may be disposed coplanar with the upper surfaces of the first contact patterns 170.

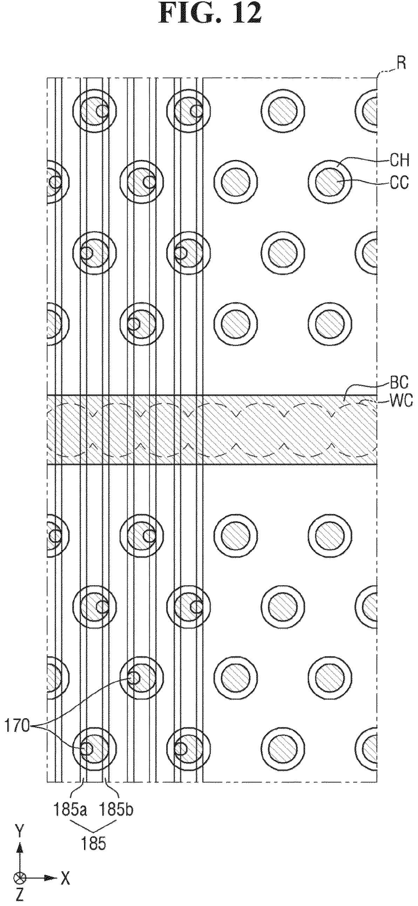

FIG. 12 is a layout view for explaining a semiconductor memory device according to some example embodiments of the present disclosure. For convenience, descriptions of content that overlaps with what has been described above with reference to FIGS. 1 through 11 will be simplified or omitted.

Referring to FIGS. 3 and 12, in the semiconductor memory device according to some example embodiments of the present disclosure, the sides of a cutting pattern WC may include curved surfaces.

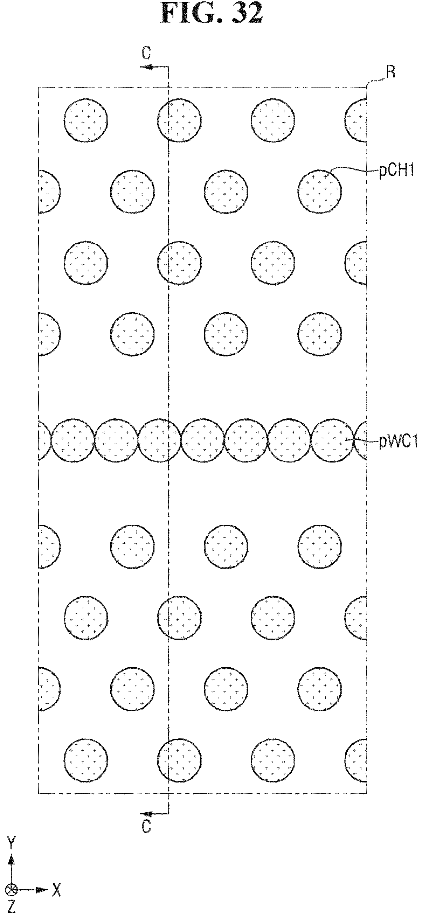

For example, as illustrated in FIG. 12, from a planar perspective, the sides of the cutting pattern WC may have a shape formed by connecting a plurality of arcs along a first direction X. This may be because an etching process for forming the cutting pattern WC connects a plurality of holes that are arranged along the first direction X. The formation of the cutting pattern WC will be described later in further detail with reference to FIGS. 32 through 42.

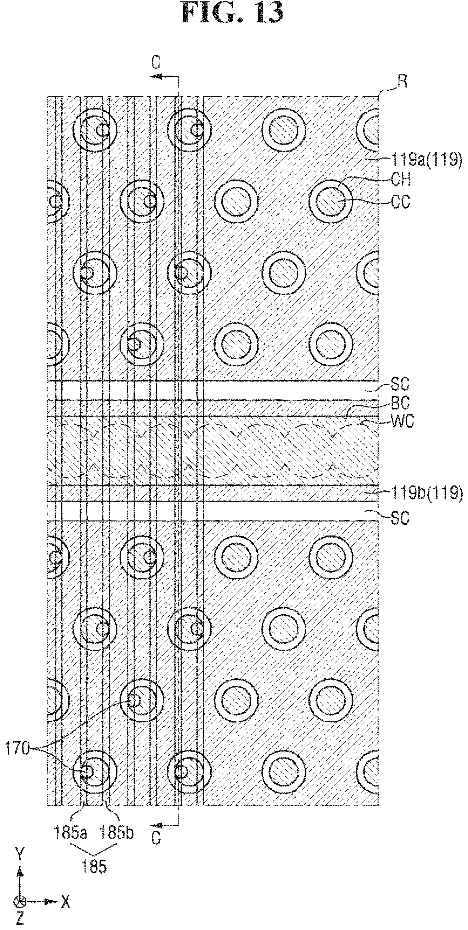

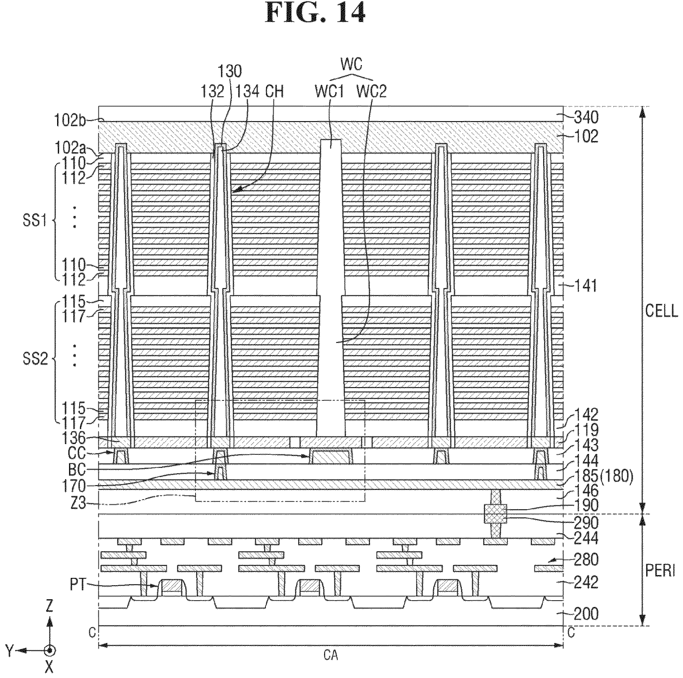

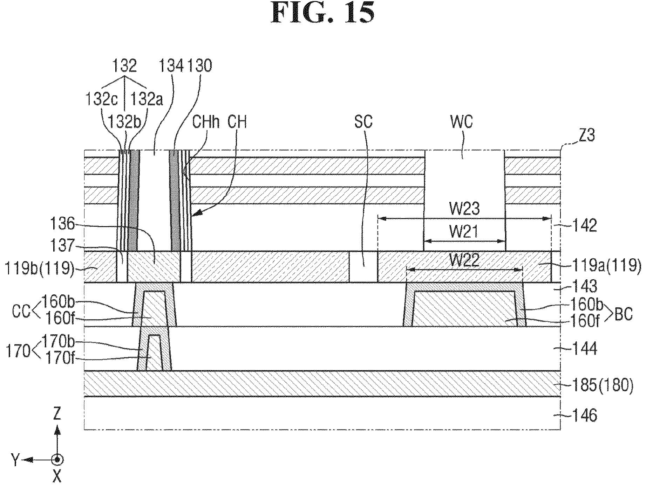

FIG. 13 is a layout view for explaining a semiconductor memory device according to some example embodiments of the present disclosure. FIG. 14 is a cross-sectional view taken along line C-C of FIG. 13. FIG. 15 is an enlarged cross-sectional view of an area Z3 of FIG. 14. For convenience, descriptions of content that overlaps with what has been described above with reference to FIGS. 1 through 12 will be simplified or omitted.

Referring to FIGS. 13 through 15, the semiconductor memory device according to some example embodiments of the present disclosure may further include a gate pattern 119.

The gate pattern 119 may be interposed between a stack structure (SS1 and SS2) and cell wiring structures 180 and between a cutting pattern WC and the cell wiring structures 180. The gate pattern 119 may have a layered structure extending in a horizontal direction (for example, a first or second direction X or Y). The gate pattern 119 may be spaced apart from gate electrodes (112 and 117). For example, the gate pattern 119 may be stacked on a second interlayer insulating film 142. Channel structures CH may extend in a third direction Z and penetrate the gate pattern 119.

The gate pattern 119 may include a conductive material, for example, polysilicon doped with impurities, a metal, or a metal silicide, but the present disclosure is not limited thereto. In some example embodiments, the gate pattern 119 may be provided as one or more string select lines (for example, the string select lines SSL of FIG. 2) in the semiconductor memory device according to some example embodiments of the present disclosure.

In some example embodiments, a blocking pattern BC may directly contact the gate pattern 119. For example, a third interlayer insulating film 143 may cover the gate patterns 119, and the blocking pattern BC may be formed within the third interlayer insulating film 143 to contact the lower surface of the gate pattern 119. The width of the blocking pattern BC may decrease closer to the gate pattern 119.

In some example embodiments, channel pads 136 may be formed within the gate pattern 119. The gate pattern 119 may be spaced apart from the channel pads 136. For example, as illustrated in FIG. 15, a gate dielectric film 137, which surrounds the outer surfaces of the channel pads 136, may be formed between the channel pads 136 and the gate pattern 119. The gate dielectric film 137 may include, for example, at least one of silicon oxide, silicon nitride, silicon oxynitride, and a high-k material with a greater dielectric constant than silicon oxide, but the present disclosure is not limited thereto.

In some example embodiments, isolation patterns SC may be formed within the gate pattern 119. The isolation patterns SC may extend in the first direction X and may thereby cut the gate pattern 119. Memory cell blocks defined by the cutting pattern WC may be divided by the isolation patterns SC, forming a plurality of string regions.

In some example embodiments, the gate pattern 119 may include first portions 119b and a second portion 119a. The first portions 119b may be portions of the gate pattern 119 that intersect the channel structures CH. For example, the channel pads 136 may be disposed in the first portions 119b. The second portion 119a may be a portion of the gate pattern 119 that overlaps with the cutting pattern WC. For example, the second portion 119a may be interposed between the cutting pattern WC and the blocking pattern BC. The first portions 119b and the second portion 119a may be separated from one another by the isolation patterns SC extending in the first direction X. Accordingly, the first portions 119b of the gate pattern 119 may be provided as string select lines (for example, the string select lines SSL of FIG. 2) for the memory cell blocks defined by the cutting pattern WC.

In some example embodiments, the second portion 119a of the gate patterns 119 may have a greater width than the blocking pattern BC. Here, the term "width" refers to the width in the second direction Y. For example, at the interface between the blocking pattern BC and the gate pattern 119 (or the interface between the third interlayer insulating film 143 and the gate pattern 119), a width W23 of the second portion 119a of the gate patterns 119 may be greater than a width W22 of the blocking patterns BC.

A method of fabricating a semiconductor memory device according to some example embodiments of the present disclosure will hereinafter be described with reference to FIGS. 1 through 42.

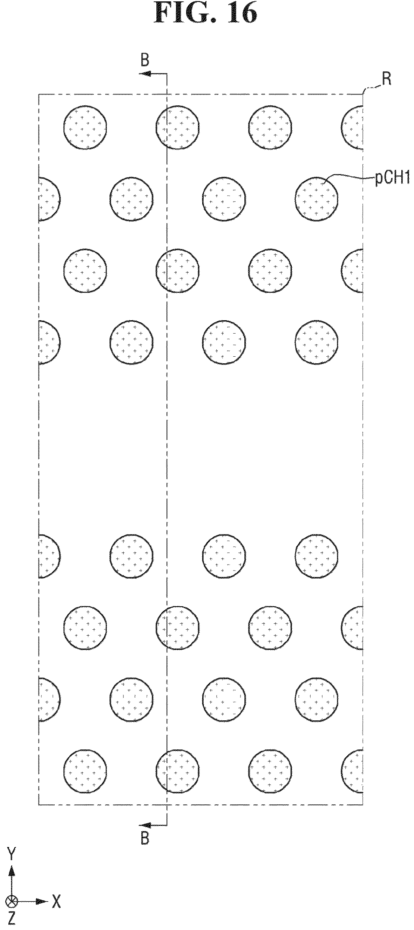

FIGS. 16 through 31 are cross-sectional views illustrating intermediate steps of a method of fabricating a semiconductor memory device according to some example embodiments of the present disclosure. For convenience, descriptions of content that overlaps with what has been described above with reference to FIGS. 1 through 15 will be simplified or omitted.

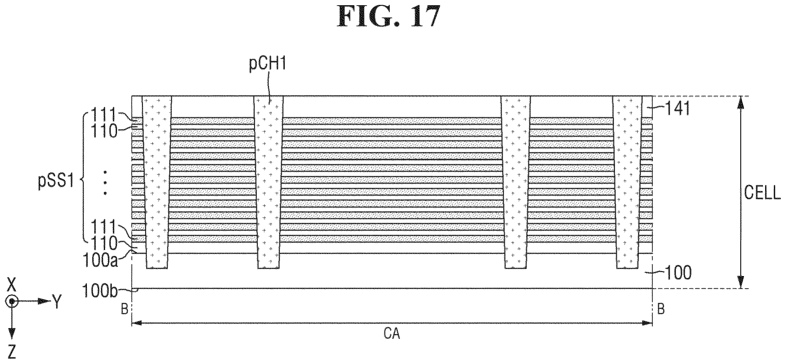

Referring to FIGS. 16 and 17, a first preliminary stack pSS1 and first preliminary channels pCH1 are formed on a base substrate 100. FIG. 17 is a cross-sectional view taken along line B-B of FIG. 16.

The base substrate 100 may include, for example, a semiconductor substrate such as a Si substrate, a Ge substrate, or a SiGe substrate. Alternatively, the base substrate 100 may include a SOI substrate or a GOI substrate.

The base substrate 100 may include third and fourth surfaces 100a and 100b, which are opposite to each other. The third surface 100a may also be referred to as the front side of the base substrate 100, and the fourth surface 100b may also be referred to as the back side of the base substrate 100.

The first preliminary stack pSS1 may be formed on the third surface 100a of the base substrate 100. The first preliminary stack pSS1 may include a plurality of first mold insulating films 110 and a plurality of first mold sacrificial films 111, which are stacked on the base substrate 100 alternating with the first mold insulating films 110. The first mold sacrificial films 111 may include a material with an etch selectivity with respect to the first mold insulating films 110. For example, each of the first mold insulating films 110 may include a silicon oxide film, and each of the first mold sacrificial films 111 may include a silicon nitride film.

The first preliminary channels pCH1 may extend in a third direction Z and may thereby penetrate the first preliminary stack pSS1. The first preliminary channels pCH1 may be connected to the base substrate 100. For example, a first interlayer insulating film 141, which covers the first preliminary stack pSS1, may be formed on the base substrate 100. The first preliminary channels pCH1 may penetrate the first interlayer insulating film 141 and the first preliminary stack pSS1 and may thereby be connected to the base substrate 100.

The first preliminary channels pCH1 may include a material with an etch selectivity ratio with respect to the first mold insulating films 110 and the first mold sacrificial films 111. For example, the first preliminary channels pCH1 may include poly Si.

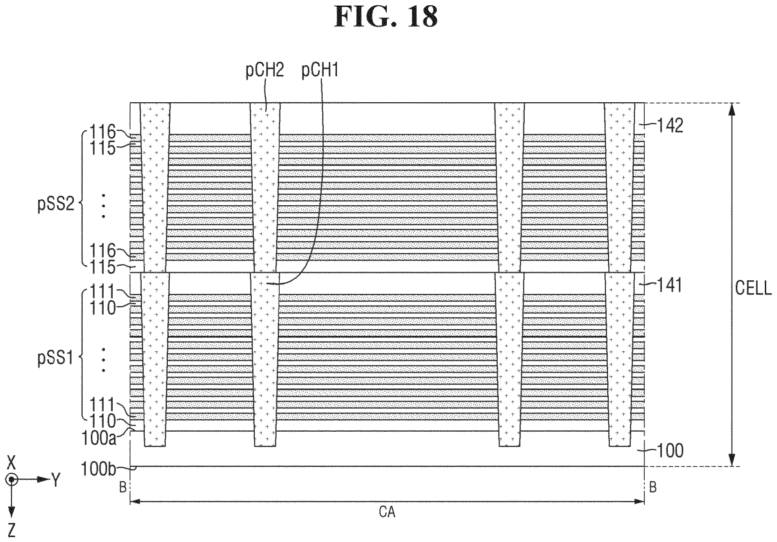

Referring to FIG. 18, a second preliminary stack pSS2 and second preliminary channels pCH2 are formed on the first preliminary stack pSS1 and the first preliminary channels pCH1.

The second preliminary stack pSS2 may include a plurality of second mold insulating films 115 and a plurality of second mold sacrificial films 116, which are stacked on the first preliminary stack pSS1 alternating with the second mold insulating films 115. The formation of the second preliminary stack pSS2 may be similar to the formation of the first preliminary stack pSS1, and thus, a detailed description thereof will be omitted.

The second preliminary channels pCH2 may extend in the third direction Z and may thereby penetrate the second preliminary stack pSS2. Additionally, the second preliminary channels pCH2 may be connected to the first preliminary channels pCH1. The formation of the second preliminary channels pCH2 may be similar to the formation of the first preliminary channels pCH1, and thus, a detailed description thereof will be omitted.

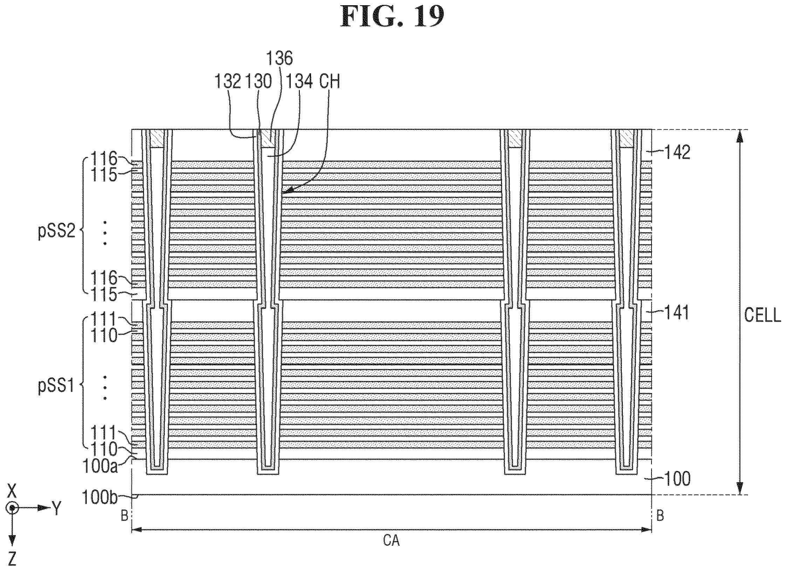

Referring to FIG. 19, channel structures CH are formed.

For example, the first preliminary channels pCH1 and the second preliminary channels pCH2 may be selectively removed. Thereafter, the channel structures CH may be formed in the areas from which the first preliminary channels pCH1 and the second preliminary channels pCH2 have been removed. In this manner, channel structures CH that extend in the third direction Z to penetrate the first and second preliminary stacks pSS1 and pSS2 and be connected to the base substrate 100 may be formed. In some example embodiments, the channel structures CH may include semiconductor films 130, data storage films 132, fill insulating films 134, and channel pads 136.

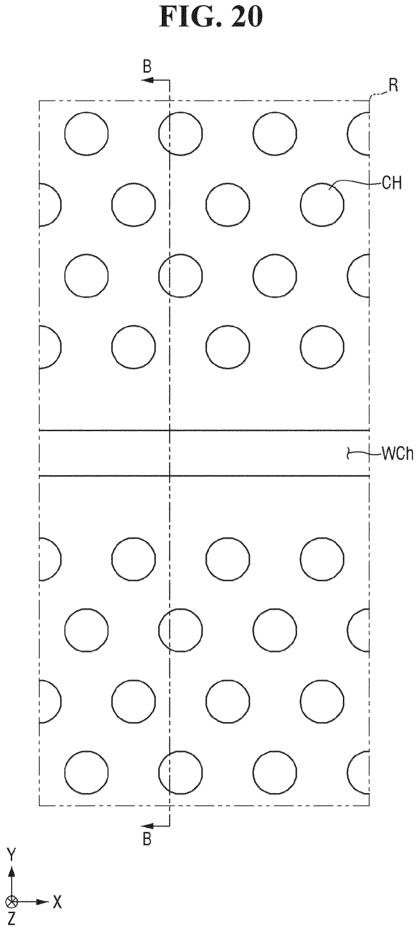

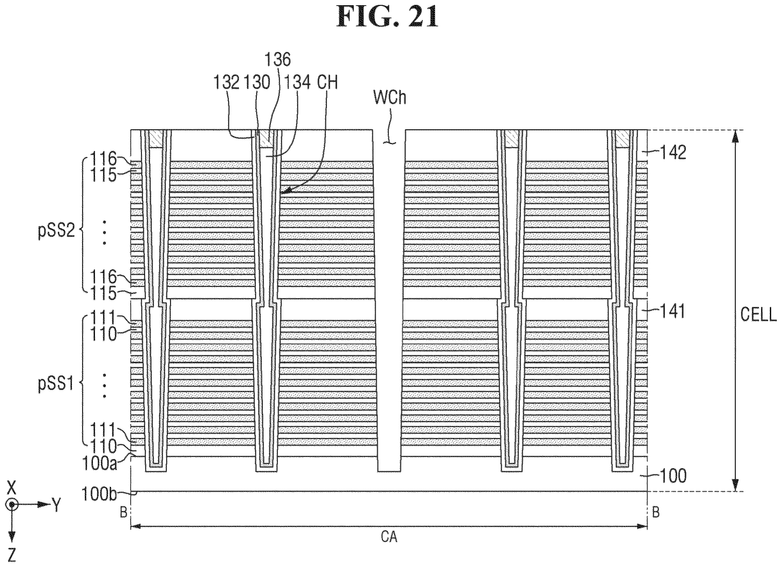

Referring to FIGS. 20 and 21, a cutting area WCh is formed. FIG. 21 is a cross-sectional view taken along line B-B of FIG. 20.

The cutting area WCh may extend in a first direction X and may cut the first and second preliminary stacks pSS1 and pSS2.

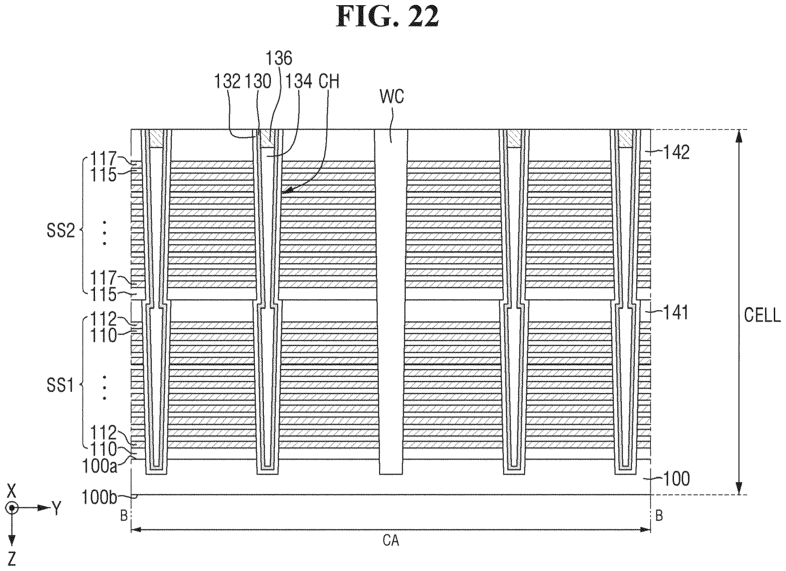

Referring to FIG. 22, a plurality of gate electrodes (112 and 117) are formed.

For example, mold sacrificial layers (111 and 116) exposed by the cutting area (WCh) may be selectively removed. Thereafter, the gate electrodes (112 and 117) may be formed in the areas from which the mold sacrificial layers (111 and 116) have been removed. Consequently, a stack structure (SS1 and SS2) including mold insulating films (110 and 115) and the gate electrodes (112 and 117) may be formed. In some example embodiments, after the formation of the stack structure (SS1 and SS2), the cutting area WCh may be filled with an insulating material. As a result, a cutting pattern WC that extends in the first direction X and thereby cuts the stack structure (SS1 and SS2) may be formed.

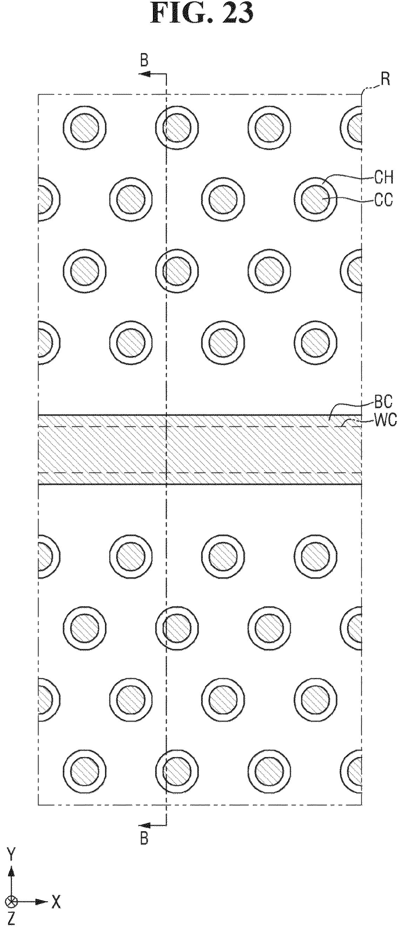

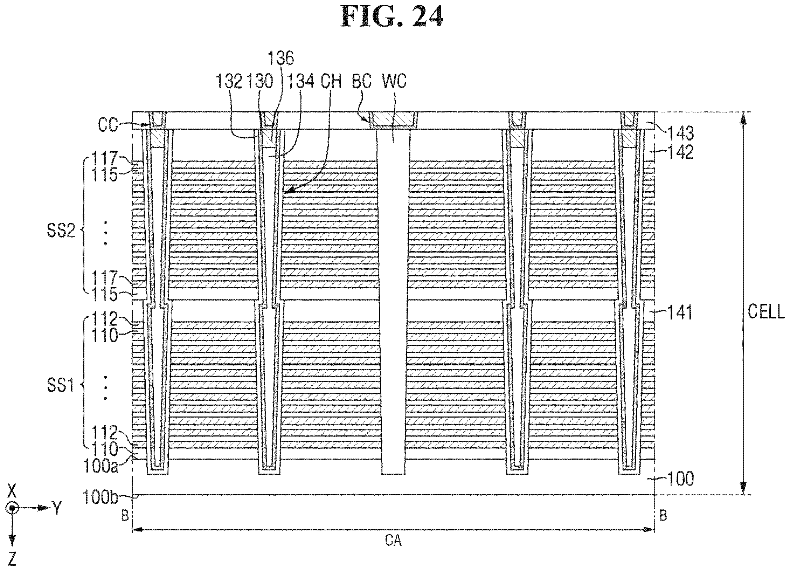

Referring to FIGS. 23 and 24, channel contacts CC and a blocking pattern BC (or a line pattern) are formed. FIG. 24 is a cross-sectional view taken along line B-B of FIG. 23.

For example, a third interlayer insulating film 143, which covers the channel structures CH and a second interlayer insulating film 142, may be formed. The channel contacts CC may penetrate the third interlayer insulating film 143 and may thereby be connected to the channel structures CH. The blocking pattern BC may extend longitudinally in the first direction X within the third interlayer insulating film 143 and may overlap with the cutting pattern WC in the third direction Z. In some example embodiments, the blocking pattern BC may be formed at the same level as the channel contacts CC.

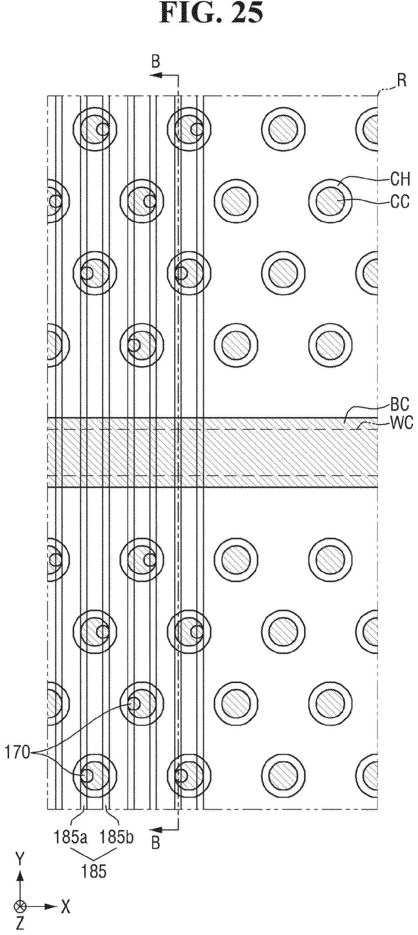

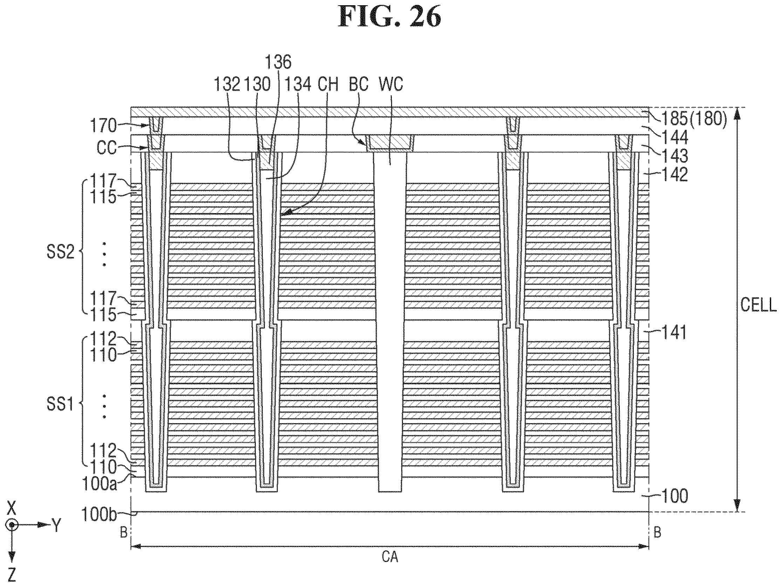

Referring to FIGS. 25 and 26, first contact patterns 170 and cell wiring structures 180 are formed. FIG. 26 is a cross-sectional view taken along line B-B of FIG. 25.

For example, a fourth interlayer insulating film 144, which covers the third interlayer insulating film 143, the channel contacts CC, and the blocking pattern BC, may be formed. The first contact patterns 170 may penetrate the fourth interlayer insulating film 144 and may thereby be connected to the channel contacts CC. The cell wiring structures 180 may be formed on the fourth interlayer insulating film 144. The cell wiring structures 180 may be electrically connected to the first contact patterns 170. In some example embodiments, the cell wiring structures 180 may extend longitudinally in the second direction Y and may include conduction lines 185, which are connected to the first contact patterns 170.

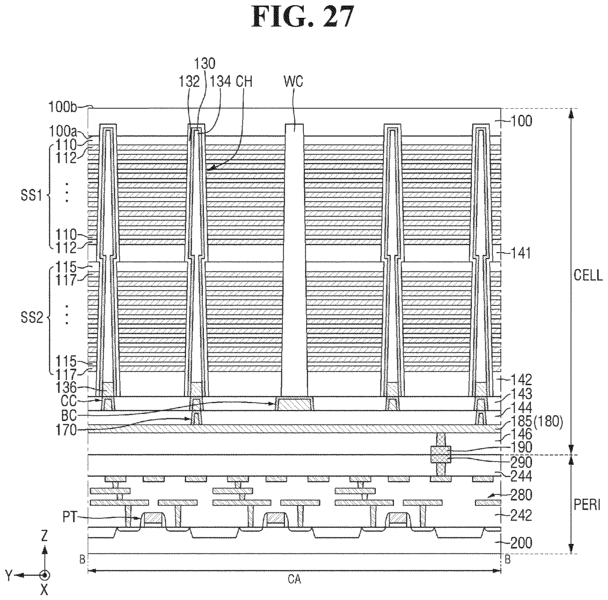

Referring to FIG. 27, a memory cell structure CELL is stacked on a peripheral circuit structure PERI.

In some example embodiments, the memory cell structure CELL may be stacked such that the third surface 100a of the base substrate 100 may face the peripheral circuit structure PERI. For example, the first bonding metals 190 and/or the first bonding insulating film 146 formed in the uppermost metal layer of the memory cell structure CELL may be bonded to second bonding metals 290 and/or a second bonding insulating film 246 formed in the uppermost metal layer of the peripheral circuit structure PERI.

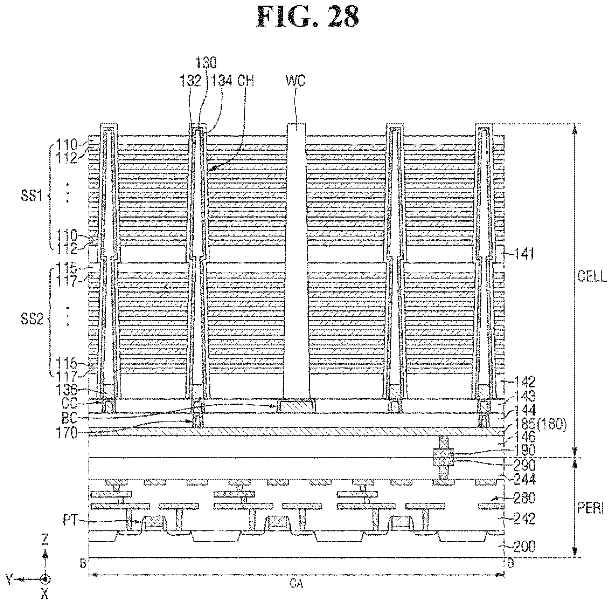

Referring to FIG. 28, at least part of the base substrate 100 is removed.

For example, a planarization process or a recess process may be performed on the fourth surface 100b of the base substrate 100. As a result, ends (for example, upper ends) of the channel structures CH may be exposed.

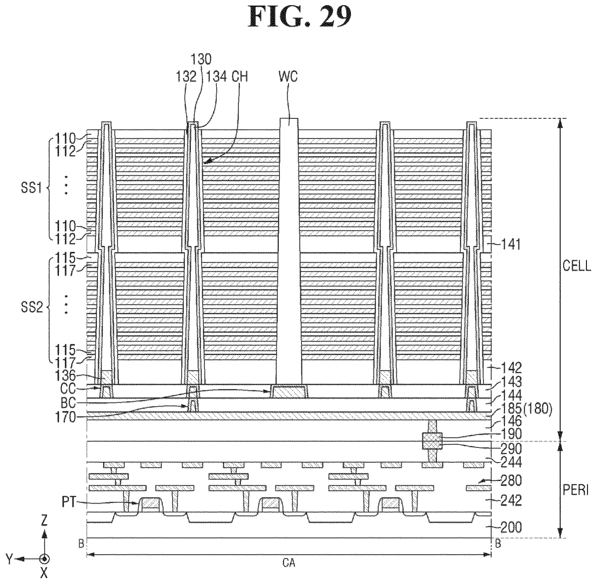

Referring to FIG. 29, upper portions of the data storage films 132 are removed.

For example, an etching process may be performed on the data storage films 132 of the exposed channel structures CH. As a result, the ends (for example, the upper ends) of the semiconductor films 130 of the channel structures CH may be exposed.

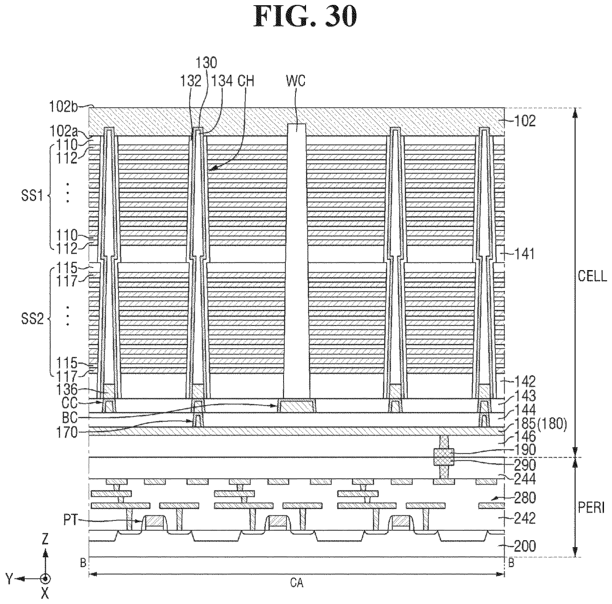

Referring to FIG. 30, a source layer 102 is formed on the stack structure (SS1 and SS2) and the channel structures CH.

The source layer 102 may be formed in the area from which the base substrate 100 has been removed. Consequently, a source layer 102 that is connected to the semiconductor films 130 of the channel structures CH may be formed. The source layer 102 may include a conductive material, for example, doped polysilicon, a metal, or a metal silicide, but the present disclosure is not limited thereto. For example, the source layer 102 may include poly-Si doped with N-type impurities, such as P or As.

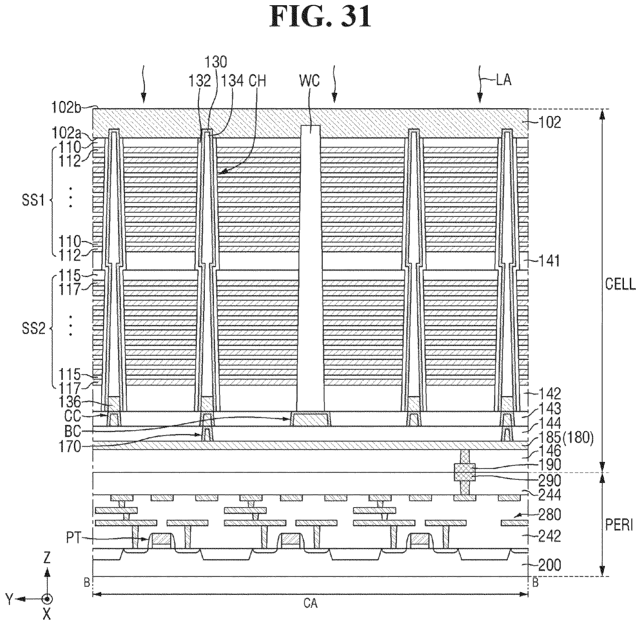

Referring to FIG. 31, a laser annealing process LA is performed on the source layer 102.

As the laser annealing process LA is performed, the impurities included in the source layer 102 may be activated. Unlike a typical general annealing process, the laser annealing process LA may be performed locally on the source layer 102, thereby minimizing damage to the semiconductor memory device.

Also, as described earlier, the blocking pattern BC can prevent or reduce defects in the cell wiring structures 180 by blocking laser light passing through the cutting pattern WC during the laser annealing process LA. Therefore, a method of fabricating a semiconductor memory device with improved reliability can be provided.

Thereafter, referring to FIG. 7, an upper insulating film 340 is formed on the source layer 102. In this manner, the semiconductor memory device of FIGS. 3 through 8 can be obtained.

FIGS. 32 through 42 are cross-sectional views illustrating intermediate steps of a method of fabricating a semiconductor memory device according to some example embodiments of the present disclosure. For convenience, descriptions of content overlapping with what has been described above with reference to FIGS. 1 through 31 will be simplified or omitted.

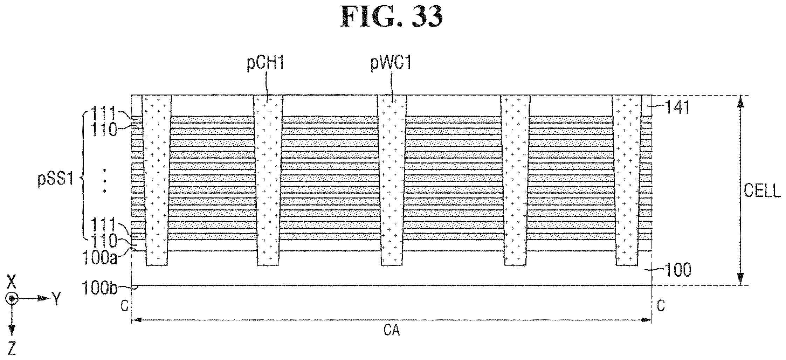

Referring to FIGS. 32 and 33, a first preliminary stack pSS1, first preliminary channels pCH1, and a first preliminary cutting pattern pWC1 are formed on a base substrate 100. FIG. 33 is a cross-sectional view taken along line C-C of FIG. 32.

The first preliminary cutting pattern pWC1 may extend in a third direction Z, penetrating the first preliminary stack pSS1. A plurality of first preliminary cutting patterns pWC1 may be arranged in a first direction X. In some example embodiments, the first preliminary cutting pattern pWC1 may be formed at the same level as the first preliminary channels pCH1.

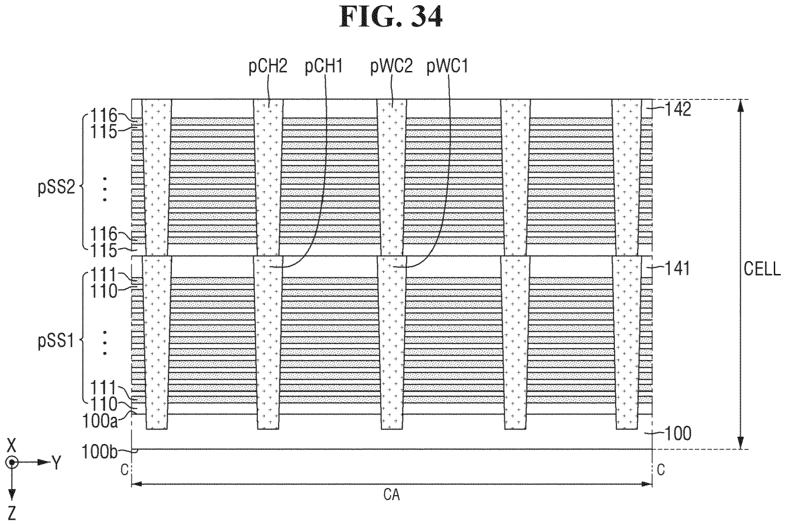

Referring to FIG. 34, a second preliminary stack pSS2, a second preliminary channels pCH2, and a second preliminary cutting pattern pWC2 are formed on the first preliminary stack pSS1, the first preliminary channels pCH1, and the first preliminary cutting pattern pWC1, respectively.

The second preliminary cutting pattern pWC2 may extend in the third direction Z, penetrating the second preliminary stack pSS2. Additionally, the second preliminary cutting pattern pWC2 may be connected to the first preliminary cutting pattern pWC1. A plurality of second preliminary cutting patterns pWC2 may be arranged in the first direction X. In some example embodiments, the second preliminary cutting pattern pWC2 may be formed at the same level as the second preliminary channel pCH2.

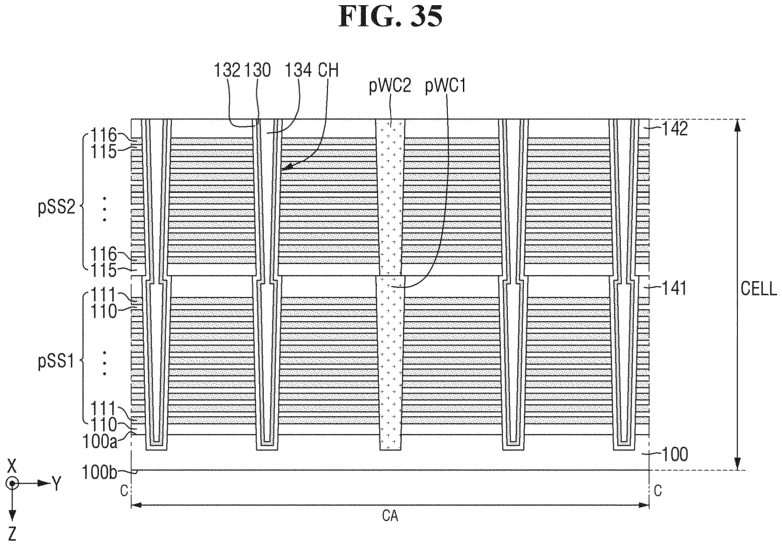

Referring to FIG. 35, channel structures CH are formed. The formation of the channel structures CH may be almost as described above with reference to FIG. 19, and thus, a detailed description thereof will be omitted.

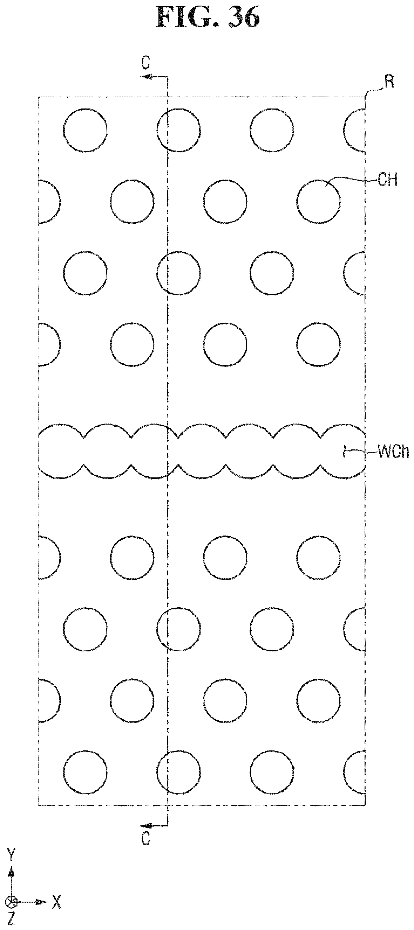

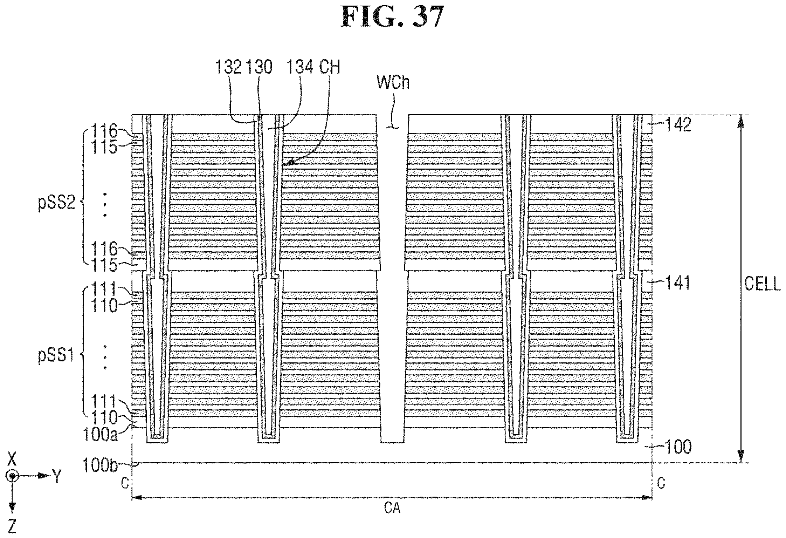

Referring to FIGS. 36 and 37, a cutting area WCh is formed. FIG. 37 is a cross-sectional view taken along line C-C of FIG. 36.

For example, the first and second preliminary cutting patterns pWC1 and pWC2 may be selectively removed. Thereafter, a recess process may be performed on the area from which the first and second preliminary cutting patterns pWC1 and pWC2 have been removed. Consequently, a cutting area WCh that extends in the first direction X and thereby cuts the first and second preliminary stacks pSS1 and pSS2 may be formed.

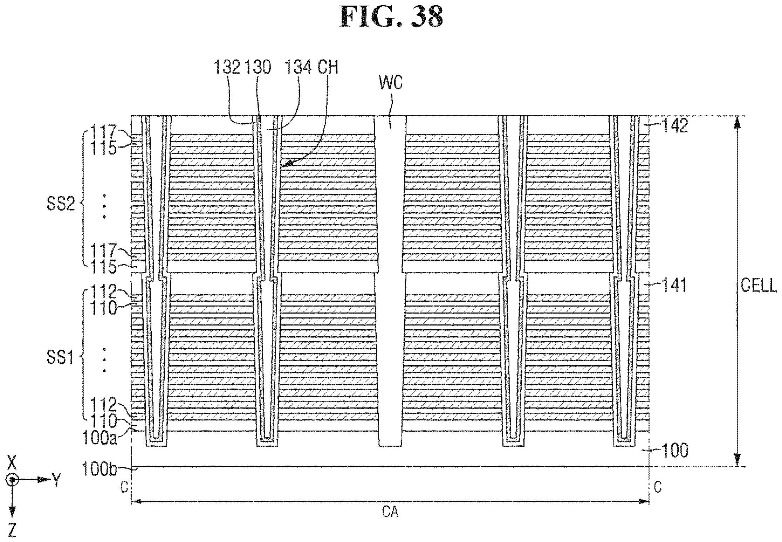

Referring to FIG. 38, a plurality of gate electrodes (112 and 117) and a cutting pattern WC are formed. The formation of the gate electrodes (112 and 117) and the cutting pattern WC may be almost as described above with reference to FIG. 22, and thus, a detailed description thereof will be omitted.

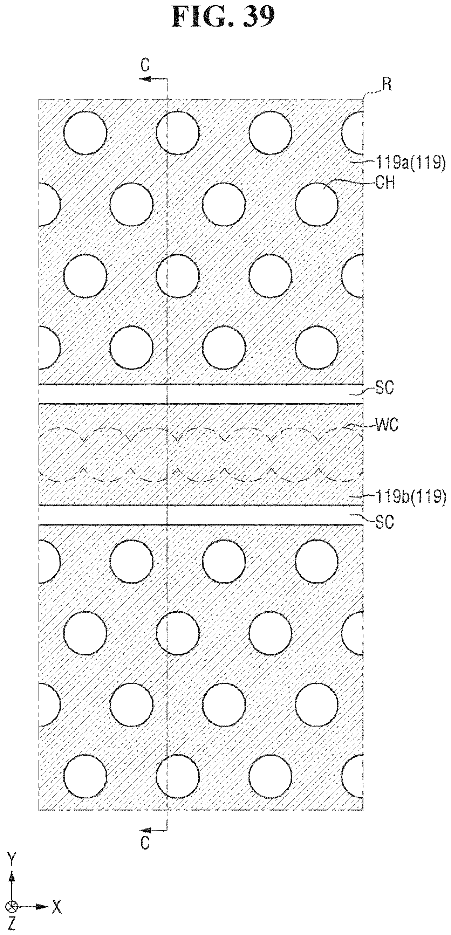

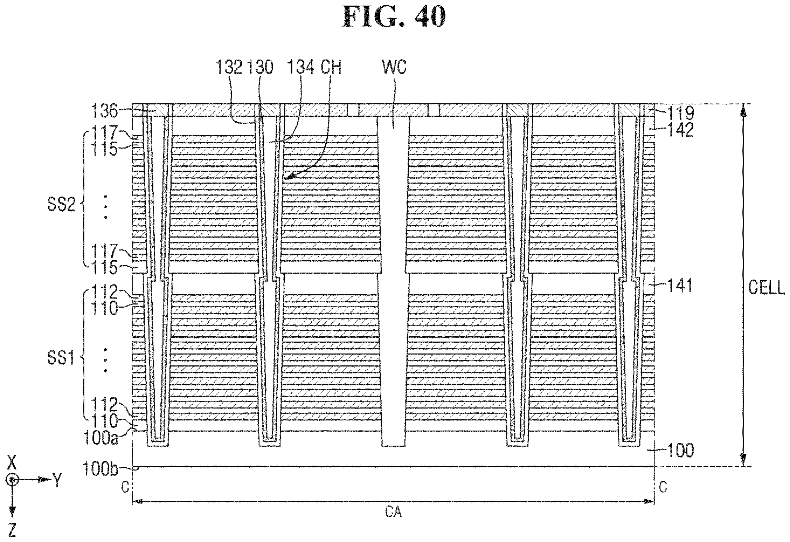

Referring to FIGS. 39 and 40, a gate pattern 119 and channel pads 136 are formed. FIG. 40 is a cross-sectional view taken along line C-C of FIG. 39.

The gate pattern 119 may be formed on a stack structure (SS1 and SS2) and the cutting pattern WC. The gate pattern 119 may be spaced apart from the gate electrodes (112 and 117). The gate pattern 119 may include a conductive material, for example, polysilicon doped with impurities, a metal, or a metal silicide, but the present disclosure is not limited thereto.

In some example embodiments, isolation patterns SC may be formed within the gate pattern 119. The isolation patterns SC may extend in the first direction X and may thereby cut the gate pattern 119.

The channel pads 136 may be formed within the gate pattern 119. The channel pads 136 may be connected to the semiconductor films 130 in the channel structures CH. The channel structures CH, including the channel pads 136, may extend in the third direction Z and may thereby penetrate the gate pattern 119. The channel pads 136 may be formed at the same level as the gate pattern 119, but the present disclosure is not limited thereto.

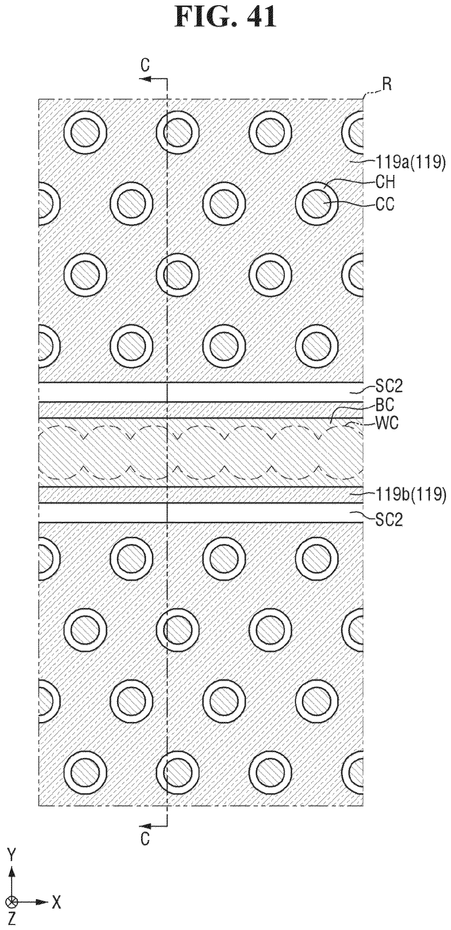

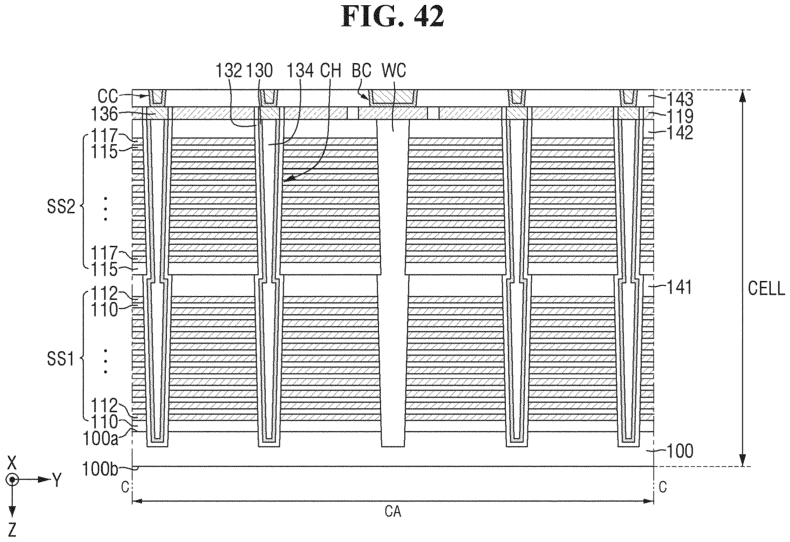

Referring to FIGS. 41 and 42, channel contacts CC and a blocking pattern BC are formed. FIG. 42 is a cross-sectional view taken along line C-C of FIG. 41. The formation of the channel contacts CC and the blocking pattern BC may be almost as described above with reference to FIGS. 23 and 24, and thus, a detailed description thereof will be omitted.

Thereafter, the processes described above with reference to FIGS. 25 through 31 may be performed. In this manner, the semiconductor memory device of FIGS. 13 through 15 can be obtained.

An electronic system including a semiconductor memory device according to some example embodiments of the present disclosure will hereinafter be described with reference to FIGS. 1 through 45.

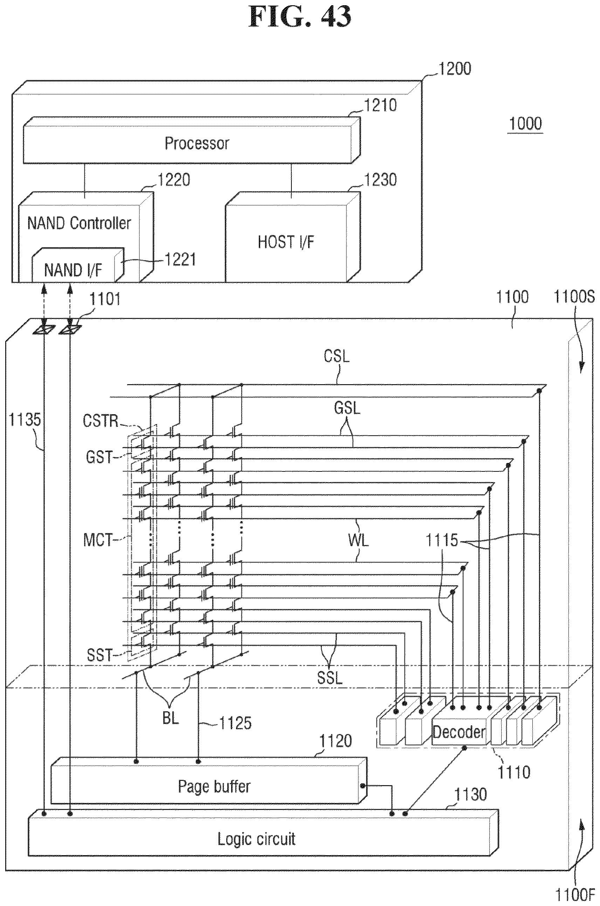

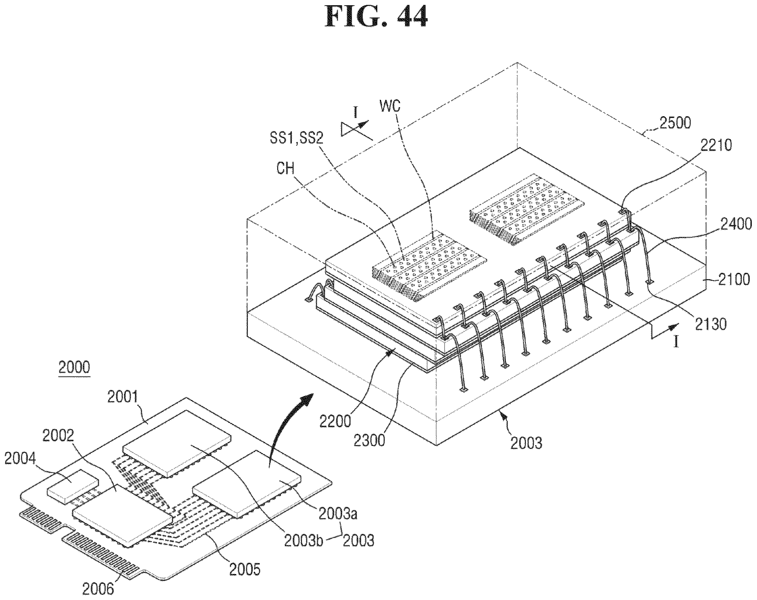

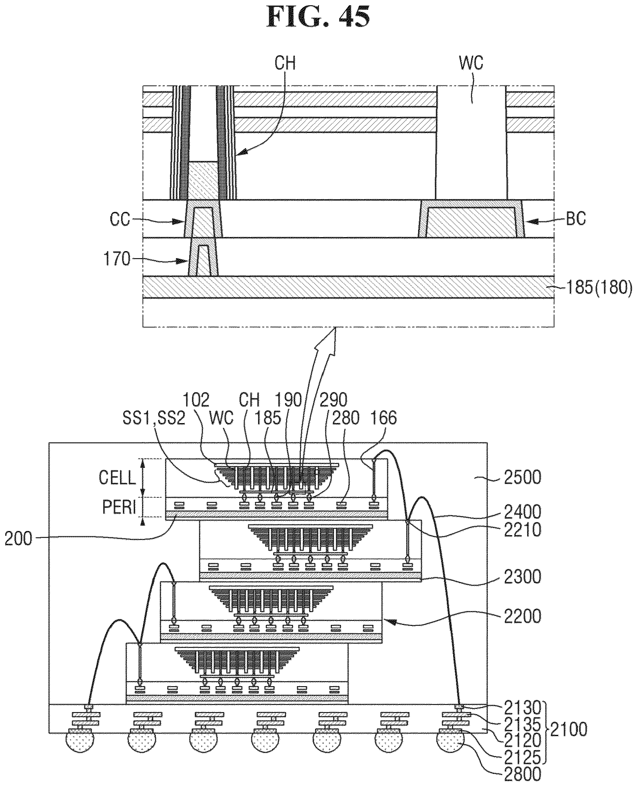

FIG. 43 is a block diagram for explaining an electronic system according to some example embodiments of the present disclosure. FIG. 44 is a perspective view for explaining an electronic system according to some example embodiments of the present disclosure. FIG. 45 is a cross-sectional view taken along line I-I of FIG. 44.

Referring to FIG. 43, an electronic system 1000 may include a semiconductor memory device 1100 and a controller 1200, which is electrically connected to the semiconductor memory device 1100. The electronic system 1000 may be a storage device that includes at least one semiconductor memory device 1100 or an electronic device that includes a storage device. For example, the electronic system 1000 may be a solid-state drive (SSD) device, a universal serial bus (USB), a computing system, a medical device, or a communication device that includes at least one semiconductor memory device 1100.

The semiconductor memory device 1100 may be a non-volatile memory device (for example, a NAND flash memory device) and may include, for example, at least one of the semiconductor memory devices depicted in FIGS. 1 through 16. The semiconductor memory device 1100 may include a first structure 1100F and a second structure 1100S on the first structure 1100F.

The first structure 1100F may be a peripheral circuit structure including a decoder circuit 1110 (for example, the row decoder 33 of FIG. 1), a page buffer 1120 (for example, the page buffer 35 of FIG. 1), and a logic circuit 1130 (for example, the control logic 37 of FIG. 1). The first structure 1100F may correspond to, for example, the peripheral circuit structure PERI of any one of FIGS. 1 through 16.

The second structure 11005 may include a common source line CSL, a plurality of bitlines BL, and a plurality of cell strings CSTR, as described above with reference to FIG. 2. The cell strings CSTR may be connected to the decoder circuit 1110 through wordlines WL, one or more string select lines SSL, and one or more ground select lines GSL. Furthermore, the cell strings CSTR may be connected to the page buffer 1120 through the bitlines BL. The second structure 1100S may correspond to, for example, the memory cell structure CELL of any one of FIGS. 1 through 16.

In some example embodiments, the common source line CSL and the cell strings CSTR may be electrically connected to the decoder circuit 1110 through first connection wires 1115, which extend from the first structure 1100F to the second structure 11005.

In some example embodiments, the bitlines BL may be electrically connected to the page buffer 1120 through second connection wires 1125.

The semiconductor memory device 1100 may communicate with the controller 1200 through input/output pads 1101, which are electrically connected to the logic circuit 1130 (for example, the control logic 37 of FIG. 1). The input/output pads 1101 may correspond to the conductive pads 390 of any one of FIGS. 1 through 16. The input/output pads 1101 may be electrically connected to the logic circuit 1130 through input/output connection wires 1135, which extend from the first structure 1100F to the second structure 1100S. The connection wires 1135 may correspond to, for example, the through vias 166 of any one of FIGS. 1 through 16.

The controller 1200 may include a processor 1210, a NAND controller 1220, and a host interface 1230. In some example embodiments, the electronic system 1000 may include a plurality of semiconductor memory devices 1100, in which case, the controller 1200 may control the plurality of semiconductor memory devices 1100.

The processor 1210 may control the operation of the entire electronic system 1000 that includes the controller 1200. The processor 1210 may operate in accordance with specific, or desired, firmware and may control the NAND controller 1220 to access the semiconductor memory device 1100. The NAND controller 1220 may include the NAND interface 1221, which processes communication with the semiconductor memory device 1100. Control commands for controlling the semiconductor memory device 1100, data to be written to memory cell transistors MCT of the semiconductor memory device 1100, and data to be read from the memory cell transistors MCT of the semiconductor memory device 1100 may be transmitted through the NAND interface 1221. The host interface 1230 may provide communication capabilities between the electronic system 1000 and an external host. In response to receiving control commands from the external host through the host interface 1230, the processor 1210 may control the semiconductor memory device 1100.

Referring to FIGS. 44 and 45, an electronic system 2000 may include a main substrate 2001 and a main controller 2002, one or more semiconductor packages 2003, and a DRAM 2004, which are mounted on the main substrate 2001. The semiconductor packages 2003 and the DRAM 2004 may be connected to the main controller 2002 via wiring patterns 2005, which are formed on the main substrate 2001.

The main substrate 2001 may include a connector 2006, which includes a plurality of pins to be coupled to the external host. The number and arrangement of the pins in the connector 2006 may vary depending on the communication interface between the electronic system 2000 and the external host. In some example embodiments, the electronic system 2000 may communicate with the external host according to one of the following interfaces: USB, PCI-Express, SATA, and M-Phy for UFS. In some example embodiments, the electronic system 2000 may operate on power supplied by the external host through the connector 2006. The electronic system 2000 may further include a power management integrated circuit (PMIC), which distributes the power supplied from the external host to the main controller 2002 and the semiconductor packages 2003.

The main controller 2002 may write data to the semiconductor packages 2003 or read data from the semiconductor packages 2003. The main controller 2002 may improve the operating speed of the electronic system 2000.

The DRAM 2004 may serve as a buffer memory to mitigate the speed difference between the semiconductor packages 2003, which are data storage spaces, and the external host. The DRAM 2004, which is included in the electronic system 2000, may function as a cache memory and may provide a temporary storage space for control operations for the semiconductor packages 2003. If the electronic system 2000 includes the DRAM 2004, the main controller 2002 may further include a DRAM controller for controlling the DRAM 2004, in addition to a NAND controller for controlling the semiconductor packages 2003.

The semiconductor packages 2003 may include first and second semiconductor packages 2003a and 2003b, which are spaced apart from each other. The first and second semiconductor packages 2003a and 2003b may both be semiconductor packages that include a plurality of semiconductor chips 2200. Each of the first and second semiconductor packages 2003a and 2003b may include a package substrate 2100, semiconductor chips 2200, which are on the package substrate 2100, adhesive layers 2300, which are disposed on the lower surfaces of the semiconductor chips 2200, connection structures 2400, which electrically connect the semiconductor chips 2200 and the package substrate 2100, and a molding layer 2500, which covers the semiconductor chips 2200 and the connection structures 2400 on the package substrate 2100.

The package substrate 2100 may be a PCB including package upper pads 2130. Each of the semiconductor chips 2200 may include input/output pads 2210. The input/output pads 2210 may correspond to the input/output pads 1101 of FIG. 43.

In some example embodiments, the connection structures 2400 may be bonding wires that electrically connect the input/output pads 2210 and the package upper pads 2130. Thus, in each of the first and second semiconductor packages 2003a and 2003b, the semiconductor chips 2200 may be electrically connected to one another through bonding wires and may also be electrically connected to the package upper pads 2130 of the package substrate 2100. Alternatively, in some example embodiments, the semiconductor chips 2200 in each of the first and second semiconductor packages 2003a and 2003b may be electrically connected to one another through connection structures that include through silicon vias (TSVs), rather than through the connection structures 2400, which are bonding wires.

In some example embodiments, the main controller 2002 and the semiconductor chips 2200 may be included within a single package. In some example embodiments, the main controller 2002 and the semiconductor chips 2200 may be mounted on a separate interposer substrate from the main substrate 2001, and may be connected to one another by wires formed on the interposer substrate.

In some example embodiments, the package substrate 2100 may be a PCB. The package substrate 2100 may include a package substrate body 2120, package upper pads 2130, which are disposed on the upper surface of the package substrate body 2120, lower pads 2125, which are disposed on or exposed through the lower surface of the package substrate body 2120, and internal wires 2135, which are electrically connected the upper pads 2130 and the lower pads 2125 within the package substrate body 2120. The upper pads 2130 may be electrically connected to the connection structures 2400. The lower pads 2125 may be connected to the wiring patterns 2005 of the main substrate 2001 of the electronic system 2000 through conductive connectors 2800, as illustrated in FIG. 44.

In the electronic system 2000, each of the semiconductor chips 2200 may include any one of the semiconductor memory devices depicted in FIGS. 1 through 16. For example, each of the semiconductor chips 2200 may include a memory cell structure CELL and a peripheral circuit structure PERI. For example, the memory cell structure CELL may include a source layer 102, a stack structure (SS1 and SS2), channel structures CH, cutting patterns WC, through vias 166, channel contacts CC, blocking patterns BC, first contact patterns 170, and cell wiring structures 180, as depicted in FIGS. 3 through 8. The peripheral circuit structure PERI may include a peripheral circuit substrate 200 and peripheral circuit wiring structures 280. The memory cell structure CELL and the peripheral circuit structure PERI may be bonded to each other through first bonding metals 190 and second bonding metals 290.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

In concluding the detailed description, those skilled in the art will appreciate that many variations and modifications may be made to the example embodiments without substantially departing from the principles of the present inventive concepts. Therefore, the disclosed example embodiments of the inventions are used in a generic and descriptive sense only and not for purposes of limitation.

## Claims

1. A semiconductor memory device comprising:
a source layer;
a stack structure including a plurality of gate electrodes sequentially stacked apart from one another, on the source layer;
a channel structure extending in a first direction penetrating the gate electrodes and connected to the source layer;
a cutting pattern extending in a second direction that intersects the first direction, and cutting the stack structure;
a cell wiring structure on the stack structure;
a channel contact connecting the channel structure and the cell wiring structure, between the stack structure and the cell wiring structure; and
a line pattern extending in the second direction, between the stack structure and the cell wiring structure, and overlapping with the cutting pattern in the first direction,
the line pattern being at a same level as the channel contact.

2. The semiconductor memory device of claim 1, further comprising:
a contact pattern connecting the channel contact and the cell wiring structure,
wherein the line pattern is at a different level from the contact pattern.

3. The semiconductor memory device of claim 1, wherein the line pattern is spaced apart from the cell wiring structure in the first direction.

4. The semiconductor memory device of claim 1, wherein in a third direction that intersects the first and second directions, a width of the line pattern is greater than a width of the cutting pattern.

5. The semiconductor memory device of claim 1, wherein
the cell wiring structure includes a conductive line, which extends in a third direction that intersects the first and second directions, and
the channel contact connects the channel structure and the conductive line.

6. The semiconductor memory device of claim 1, further comprising:
a peripheral circuit structure including a peripheral circuit substrate and a peripheral circuit element on the peripheral circuit substrate,
wherein the stack structure is between the source layer and the peripheral circuit structure.

7. A semiconductor memory device comprising:
a peripheral circuit structure including a peripheral circuit substrate and a peripheral circuit element on the peripheral circuit substrate; and
a memory cell structure stacked on the peripheral circuit structure,
the memory cell structure includes
a source layer including a first surface facing the peripheral circuit structure and a second surface that is opposite to the first surface;
a stack structure including a plurality of gate electrodes sequentially stacked apart from one another, on the source layer;
a channel structure extending in a first direction penetrating the gate electrodes and connected to the source layer;
a cutting pattern extending in a second direction that intersects the first direction, and cutting the stack structure;
a conductive line extending in a third direction that intersects the first and second directions, and being between the stack structure and the peripheral circuit structure;
a channel contact connecting the channel structure and the conductive line, and being between the stack structure and the conductive line; and
a line pattern extending in the second direction, being between the stack structure and the conductive line, and overlapping with the cutting pattern in the first direction.

8. The semiconductor memory device of claim 7, wherein
an upper surface of the channel contact and an upper surface of the line pattern are coplanar with each other;
the upper surface of the channel contact and a lower surface of the line pattern are coplanar with each other.

9. The semiconductor memory device of claim 7, wherein the line pattern is spaced apart from the conductive line in the first direction.

10. The semiconductor memory device of claim 7, wherein in the third direction, a width of the line pattern is greater than a width of the cutting pattern.

11. The semiconductor memory device of claim 7, further comprising:
a gate pattern between the stack structure and the conductive line and between the cutting pattern and the conductive line,
wherein the channel structure extends in the first direction to penetrate the gate pattern.

12. The semiconductor memory device of claim 11, wherein the line pattern contacts the gate pattern.

13. The semiconductor memory device of claim 11, wherein
The gate pattern includes a first portion and a second portion, the first portion penetrated by the channel structure, and the second portion between the cutting pattern and the line pattern, and
the first and second portions are spaced apart from each other by an isolation pattern extending in the second direction.

14. The semiconductor memory device of claim 13, wherein in the third direction, a width of the second portion is greater than a width of the line pattern.

15. An electronic system comprising:
a main substrate;
a semiconductor memory device including a peripheral circuit structure and a memory cell structure sequentially stacked, on the main substrate; and
a controller electrically connected to the semiconductor memory device, on the main substrate,
the memory cell structure including:
a source layer including a first surface facing the peripheral circuit structure and a second surface that is opposite to the first surface;
a stack structure including a plurality of gate electrodes sequentially stacked apart from one another, on the source layer;
a channel structure extending in a first direction, penetrating the gate electrodes and connected to the source layer;
a cutting pattern extending in a second direction that intersects the first direction, cutting the stack structure;
a conductive line extending in a third direction that intersects the first and second directions, between the stack structure and the peripheral circuit structure;
a channel contact connecting the channel structure and the conductive line, between the stack structure and the conductive line; and
a line pattern extending in the second direction, between the stack structure and the conductive line, and overlapping with the cutting pattern in the first direction.
